(19) Europäisches Patentamt
European Patent Office
Office européen des brevets

(11) **EP 4 664 796 A1**

(12) **EUROPEAN PATENT APPLICATION**
published in accordance with Art. 153(4) EPC

(43) Date of publication:
**17.12.2025 Bulletin 2025/51**

(21) Application number: **24771056.9**

(22) Date of filing: **26.01.2024**

(51) International Patent Classification (IPC):
*H04B 17/14* (2015.01)        *H04B 17/21* (2015.01)
*H04B 1/401* (2015.01)        *H03M 1/12* (2006.01)
*H03M 1/06* (2006.01)         *H03M 1/10* (2006.01)
*H04L 5/00* (2006.01)

(52) Cooperative Patent Classification (CPC):
**H03M 1/06; H03M 1/10; H03M 1/12; H04B 1/401;
H04B 17/14; H04B 17/21; H04L 5/00**

(86) International application number:
**PCT/KR2024/001282**

(87) International publication number:
**WO 2024/191055 (19.09.2024 Gazette 2024/38)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.03.2023  KR 20230032795**

(71) Applicant: **Samsung Electronics Co., Ltd.
Suwon-si, Gyeonggi-do 16677 (KR)**

(72) Inventor: **LEE, Hwankyu
Suwon-si Gyeonggi-do 16677 (KR)**

(74) Representative: **Gulde & Partner
Patent- und Rechtsanwaltskanzlei mbB
Berliner Freiheit 2
10785 Berlin (DE)**

(54) **ELECTRONIC DEVICE AND METHOD FOR IDENTIFYING ABNORMALITY IN ELECTRONIC DEVICE**

(57)    An electronic device comprises: a digital to analogue converter (DAC) circuit; an analog to digital converter (ADC) circuit; a first power amplifier circuit; a second power amplifier circuit; a coupling circuit configured to connect a transmission path between the DAC circuit and the first power amplifier circuit and a reception path between the ADC circuit and the second power amplifier; a radio frequency (RF) switch connected to the coupling circuit; an RF processing circuit connected to the RF switch; an antenna connected to the RF processing circuit; a correction circuit for correcting the output of the ADC circuit; and at least one processor. The electronic device is configured to: generate a reference signal on the basis of the mode of the electronic device being changed from a first mode to a second mode; obtain, through the reception path, a target signal changed from the reference signal; obtain a correction signal; and identify an abnormality in at least one of the correction circuit, the transmission path, or the reception path.

FIG. 7

EP 4 664 796 A1

**Description**

**[Technical Field]**

The present disclosure relates to an electronic device and a method for identifying anomaly of the electronic device. More specifically, the present disclosure relates to an electronic device and a method for identifying anomaly of an operation of RF circuitry in the electronic device including an analogue to digital converter (ADC).

**[Background Art]**

As transmission capacity increases in wireless communication systems, a function split that functionally separate base stations are being applied. According to the function split, the base station may be divided into a distributed unit (DU) and a radio unit (RU). A fronthaul interface is defined for communication between the DU and the RU.

The above-described information may be provided as a related art for the purpose of helping to understand the present disclosure. No claim or determination is raised as to whether any of the above-described information may be applied as a prior art related to the present disclosure.

**[Disclosure]**

**[Technical Solution]**

According to an embodiment, an electronic device may comprise digital to analogue converter (DAC) circuitry, analogue to digital converter (ADC) circuitry, first power amplifier circuitry, second power amplifier circuitry, coupling circuitry configured to connect a transmitting path between the DAC circuitry and the first power amplifier circuitry and a receiving path between the ADC circuitry and the second power amplifier circuitry, a radio frequency (RF) switch connected to the coupling circuitry, RF processing circuitry connected to the RF switch, an antenna connected to the RF processing circuitry, calibration circuitry for calibrating an output of the ADC circuitry, and at least one processor. The at least one processor may be configured to generate a reference signal based on a mode of the electronic device changed from a first mode in which one of the transmitting path and the receiving path is connected to the RF processing circuitry to a second mode in which the first power amplifier and the second power amplifier is activated. The at least one processor may be configured to, in response to transmitting the reference signal through the transmitting path, obtain a target signal changed from the reference signal through the receiving path. The at least one processor may be configured to obtain a calibration signal based on calibrating the target signal through the calibration circuitry. The at least one processor may be configured to, based on the reference signal and the calibration signal, identify anomaly of at least one of the calibration circuitry, the transmitting path, and the receiving path.

According to an embodiment, an electronic device may comprise an array antenna comprising a plurality of antennas, RF processing circuits coupled with the array antenna, radio frequency (RF) switches connected to the RF processing circuits, couple circuits connected to the RF switches, and at least one processor. Each of coupled circuit of the coupling circuits may be configured to connect a transmitting path for a signal transmission and a receiving path for a signal reception. The transmitting path may be configured by digital to analogue converter (DAC) circuitry and first power amplifier circuitry. The receiving path may be configured by analogue to digital converter (ADC) circuitry and second power amplifier circuitry. The at least one processor may be configured to generate a reference signal based on a mode of the electronic device changed from a first mode in which one of the transmitting path and the receiving path is connected to the RF processing circuitry to a second mode in which the RF processing circuits are controlled to be in an idle state and the first power amplifier and the second power amplifier are activated. The at least one processor may be configured to, in response to transmitting the reference signal through the transmitting path, obtain a target signal changed from the reference signal through the receiving path. The at least one processor may be configured to obtain a calibration signal based on calibrating the target signal through the calibration circuitry. The at least one processor may be configured to, based on the reference signal and the calibration signal, identify anomaly of at least one of the calibration circuitry, the transmitting path, and the receiving path.

**[Description of the Drawings]**

FIG. 1A illustrates a wireless communication system.
FIG. 1B illustrates an example of a resource division method for uplink transmission and downlink transmission.
FIG. 2 illustrates an example of a base station.

EP 4 664 796 A1

FIG. 3 illustrates an example of a resource structure in a time domain and a frequency domain.
FIG. 4 illustrates an example of channels in a communication standard.
FIGS. 5 and 6 illustrate examples of a functional configuration of an electronic device according to embodiments of the present disclosure.
FIG. 7 illustrates an example of RF circuitry for an ADC calibration process, included in an electronic device.
FIG. 8 illustrates an example of a timing diagram of signals for ADC calibration.
FIG. 9A illustrates an example of a calibration signal when an ADC calibration process is normal and spur performance of calibration circuitry is normal.
FIG. 9B illustrates an example of correlation functions when an ADC calibration process is normal and spur performance of calibration circuitry is normal.
FIG. 10A illustrates an example of a calibration signal when an ADC calibration process is abnormal.
FIG. 10B illustrates an example of correlation functions when an ADC calibration process is abnormal.
FIG. 11A illustrates an example of a calibration signal when spur performance is abnormal.
FIG. 11B illustrates an example of correlation functions when spur performance is abnormal.
FIG. 12 is a flowchart illustrating an operation of an electronic device.
FIG. 13 illustrates an example of a functional configuration of an electronic device.

**[Mode for Invention]**

Terms used in the present disclosure are used only to describe a specific embodiment, and may not be intended to limit a range of another embodiment. A singular expression may include a plural expression unless the context clearly means otherwise. Terms used herein, including a technical or a scientific term, may have the same meaning as those generally understood by a person with ordinary skill in the art described in the present disclosure. Among the terms used in the present disclosure, terms defined in a general dictionary may be interpreted as identical or similar meaning to the contextual meaning of the relevant technology and are not interpreted as ideal or excessively formal meaning unless explicitly defined in the present disclosure. In some cases, even terms defined in the present disclosure may not be interpreted to exclude embodiments of the present disclosure.
In various embodiments of the present disclosure described below, a hardware approach will be described as an example. However, since the various embodiments of the present disclosure include technology that uses both hardware and software, the various embodiments of the present disclosure do not exclude a software-based approach.
Terms referring to signals (e.g., signal, information, message, signaling), terms referring to resources (e.g., symbol, slot, subframe, radio frame, subcarrier, resource element (RE), resource block (RB), bandwidth part (BWP), occasion), terms referring to operational states (e.g., step, operation, procedure), terms referring to data (e.g., packet, user stream, information, bit, symbol, codeword), terms referring to channels, terms referring to network entities, terms referring to device components, and the like , used in the following description are exemplified for convenience of explanation. Therefore, the present disclosure is not limited to terms to be described below, and another term having an equivalent technical meaning may be used.
In addition, in the present disclosure, the term 'greater than' or 'less than' may be used to determine whether a particular condition is satisfied or fulfilled, but this is only a description to express an example and does not exclude description of 'greater than or equal to' or 'less than or equal to'. A condition described as 'greater than or equal to ' may be replaced with 'greater than', a condition described as 'less than or equal to' may be replaced with 'less than', and a condition described as ' greater than or equal to and less than' may be replaced with 'greater than and less than or equal to'. In addition, hereinafter, 'A' to 'B' refers to at least one of elements from A (including A) to B (including B). Hereinafter, 'C' and/or 'D' means including at least one of 'C' or 'D', that is, {'C', 'D', and 'C' and 'D'}.
Although the present disclosure describes various embodiments using terms used in some communication standards (e.g., 3rd Generation Partnership Project (3GPP), extensible radio access network (xRAN), open-radio access network (O-RAN)), these are only examples for explanation. The various embodiments of the present disclosure may be easily modified and applied to other communication systems.

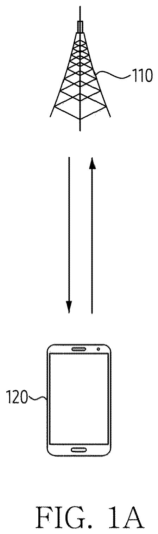

FIG. 1A illustrates a wireless communication system.
Referring to FIG. 1A, FIG. 1A illustrates a base station 110 and a terminal 120 as a portion of nodes that utilize a wireless channel in a wireless communication system. FIG. 1A illustrates only one base station, but a wireless communication system may further include another base station that is identical or similar to the base station 110.
The base station 110 is a network infrastructure that provides wireless access to the terminal 120. The base station 110 has coverage defined based on a distance at which a signal may be transmitted. In addition to 'base station', the base station 110 may be referred to as an 'access point (AP)', 'eNodeB (eNB)', '5th generation node', 'next generation nodeB (gNB)', 'wireless point', 'transmission/reception point (TRP)' or other terms having equivalent technical meanings.
The terminal 120, which is a device used by a user, performs communication with the base station 110 through a wireless channel. A link from the base station 110 to the terminal 120 is referred to as a downlink (DL), and a link from the

3

terminal 120 to the base station 110 is referred to as an uplink (UL). In addition, although not illustrated in FIG. 1A, the terminal 120 and another terminal may perform communication with each other through a wireless channel. At this time, a link (device-to-device link (D2D)) between the terminal 120 and the other terminal is referred to as a sidelink, and the sidelink may be used interchangeably with a PC5 interface. In some other embodiments, the terminal 120 may be operated without the user's involvement. According to an embodiment, the terminal 120, which is a device performing machine type communication (MTC), may not be carried by the user. Additionally, according to an embodiment, the terminal 120 may be MTC UE or a narrowband (NB)-internet of things (IoT) device.

In addition to 'terminal', the terminal 120 may also be referred to as 'user equipment (UE) ', 'customer premises equipment, (CPE) ', 'mobile station', 'subscriber station', 'remote terminal', 'wireless terminal', 'electronic device', 'user device', or other terms having equivalent technical meanings.

The base station 110 may perform beamforming with the terminal 120. The base station 110 and the terminal 120 may transmit and receive a wireless signal in a relatively low frequency band (e.g., frequency range 1 (FR 1) of NR). In addition, the base station 110 and the terminal 120 may transmit and receive a wireless signal in a relatively high frequency band (e.g., FR 2 (or FR 2-1, FR 2-2, FR 2-3) or FR 3), and a mmWave band (e.g., 28GHz, 30GHz, 38GHz, 60GHz). The base station 110 and the terminal 120 may perform beamforming to improve a channel gain. Herein, the beamforming may include transmission beamforming and reception beamforming. The base station 110 and the terminal 120 may provide directivity to a transmission signal or a reception signal. To this end, the base station 110 and the terminal 120 may select serving beams through a beam search or beam management procedure. After the serving beams are selected, subsequent communication may be performed through a resource in a QCL relationship with the resource transmitting the serving beams.

If large-scale characteristics of a channel carrying a symbol on a first antenna port may be inferred from a channel carrying a symbol on a second antenna port, the first antenna port and the second antenna port may be evaluated to be in the QCL relationship. For example, large-scale characteristics may include at least one of a delay spread, a Doppler spread, a Doppler shift, an average gain, an average delay, and a spatial receiver parameter.

Although FIG. 1A describes that both the base station 110 and the terminal 120 perform beamforming, the embodiments of the present disclosure are not necessarily limited thereto. In some embodiments, the terminal may or may not perform beamforming. In addition, the base station may or may not perform beamforming. That is, either only one of the base station and the terminal may perform beamforming, or neither the base station nor the terminal may perform beamforming.

In the present disclosure, a beam refers to a spatial flow of a signal in a wireless channel, and is formed by one or more antennas (or antenna elements), and this formation process may be referred to as beamforming. Beamforming may include at least one of analog beamforming or digital beamforming (e.g., precoding). A reference signal transmitted based on beamforming may include, for example, a demodulation-reference signal (DM-RS), a channel state information-reference signal (CSI-RS), a synchronization signal/physical broadcast channel (SS/PBCH), and a sounding reference signal (SRS). In addition, an IE such as CSI-RS resource or SRS-resource may be used as a configuration for each reference signal, and this configuration may include information associated with the beam. The information associated with the beam may mean whether a corresponding configuration (e.g., CSI-RS resource) uses the same spatial domain filter as another configuration (e.g., another CSI-RS resource within the same CSI-RS resource set) or a different spatial domain filter, or which reference signal it is quasi-co-located (QCL) with, and if so, what type it is (e.g., QCL type A, B, C, D).

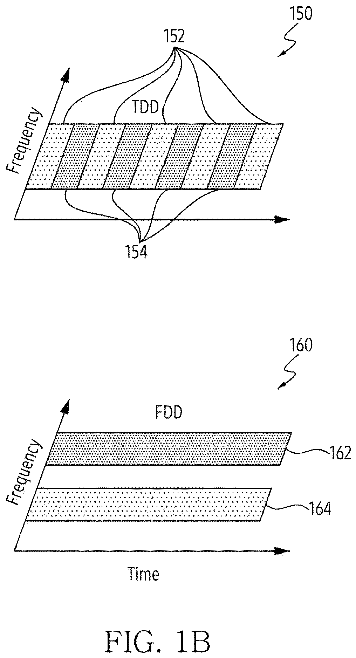

FIG. 1B illustrates an example for explaining a resource division scheme for uplink transmission and downlink transmission. The resource division scheme may include frequency division duplexing (FDD) and time division duplexing (TDD).

Referring to FIG. 1B, examples 150 and 160 of a method of dividing resources used to transmit/receive data in a downlink (DL) transmission from the base station 110 to the terminal 120 and an uplink (UL) transmission from the terminal 120 to the base station 110 are illustrated. The example 150 may indicate an example of a time division duplex (TDD) scheme, which is a method of dividing a resource for DL transmission and a resource for UL transmission over time. The example 160 may indicate an example of a frequency division duplex (FDD) scheme, which is a method of dividing a resource for DL transmission and a resource for UL transmission according to frequency.

Referring to the example 150, the base station 110 may transmit DL signals to the terminal 120 through DL resources 152. The terminal 120 may receive the DL signals transmitted from the base station 110 through the DL resources 152. The terminal 120 may transmit UL signals to the base station 110 through UL resources 154. The base station 110 may receive the UL signals transmitted from the terminal 120 through the UL resources 154. Referring to the example 150, the DL resources 152 and the UL resources 154 may be allocated different time resources. DL transmission transmitted by the base station 110 to the terminal 120 and UL transmission transmitted by the terminal 120 to the base station 110 may be performed in different time domains. The example 150 illustrates an example in which time resources of the same length are allocated to each of DL resources 152 and UL resources 154, but embodiments of the present disclosure are not limited thereto. For example, time resources of different lengths may be allocated to each of DL resources 152 and UL resources 154. In other words, a period for downlink transmission may be set differently from a period for uplink transmission. Alternatively, both DL resources 152 and UL resources 154 may be allocated time resources of different lengths. In other words, the downlink transmission and the uplink transmission may be transmitted aperiodically. Although not illustrated in the example 150, a guard period may be included between the DL resources 152 and the UL resources 154.

Referring to the example 160, the base station 110 may transmit DL signals to the terminal 120 through the DL resources 162. The terminal 120 may receive the DL signals transmitted from the base station 110 through the DL resources 162. The terminal 120 may transmit UL signals to the base station 110 through the UL resources 164. The base station 110 may receive the UL signals transmitted from the terminal 120 through the UL resources 164. Referring to the example 150, the DL resources 152 and the UL resources 154 may be allocated different frequency resources. In other words, DL transmission transmitted by the base station 110 to the terminal 120 and UL transmission transmitted by the terminal 120 to the base station 110 may be performed in different frequency domain. The example 150 illustrates an example in which frequency resources for bands of the same size are allocated to each of DL resources 152 and UL resources 154, but embodiments of the present disclosure are not limited thereto. For example, each resource of the DL resources 152 and the UL resources 154 may be allocated a frequency resources for bands having different sizes.

When comparing the example 150 and the example 160, the DL resources 152 and the UL resources 154 may be allocated a frequency resource having a wider band than the DL resources 162 and UL resources 164. For example, the base station 110 or the terminal 120 of the example 150 may transmit a larger amount of data for the same time compared to the base station 110 or the terminal 120 of the example 160. In contrast, the DL resources 162 and the UL resources 164 may be allocated a frequency resource having a narrower band than the DL resources 152 and the UL resources 154, but may be allocated a time resource having a longer time interval. For example, the base station 110 or the terminal 120 of the example 160 may transmit seamlessly (or continuously) compared to the base station 110 or the terminal 120 of the example 150.

In order to describe a TDD scheme in embodiments of the present disclosure, a resource structure of a TDD scheme defined in a communication standard (e.g., LTE or NR) is exemplarily described. According to an embodiment, the base station 110 and the terminal 120 may use a TDD scheme of LTE. The TDD scheme of LTE defines a time resource for downlink communication and a time resource for uplink communication in one radio frame. The radio frame may include a UL subframe for uplink (UL) transmission and a DL subframe for downlink (DL) transmission. The frame may include a special subframe (SSF) for switching from downlink transmission to uplink transmission. Herein, a combination of a UL subframe, a DL subframe, and a special subframe included in one frame is referred to as a UL/DL configuration. Another UL/DL configuration shows another combination of a UL subframe, a DL subframe, and a special subframe in one frame. The UL/DL configuration may be operated as shown in Table 1 below. In the following Table 1, D indicates a DL subframe, S indicates a special subframe, and U indicates a UL subframe. For example, a UL/DL configuration #2 may include six DL subframes, two UL subframes, and two special subframes, and a UL/DL configuration #5 may include eight DL subframes, one UL subframe, and one special subframe.

[Table 1]

| UL/DL configuration | Subframe number | | | | | | | | | | The number of each subframe | | |
|---|---|---|---|---|---|---|---|---|---|---|---|---|---|
| | 0 | 1 | 2 | 3 | 4 | 5 | 6 | 7 | 8 | 9 | DL | UL | S |
| 0 | D | S | U | U | U | D | S | U | U | U | 2 | 6 | 2 |
| 1 | D | S | U | U | D | D | S | U | U | D | 4 | 4 | 2 |
| 2 | D | S | U | D | D | D | S | U | D | D | 6 | 2 | 2 |
| 3 | D | S | U | U | U | D | D | D | D | D | 6 | 3 | 1 |
| 4 | D | S | U | U | D | D | D | D | D | D | 7 | 2 | 1 |
| 5 | D | S | U | D | D | D | D | D | D | D | 8 | 1 | 1 |
| 6 | D | S | U | U | U | D | S | U | U | D | 3 | 5 | 2 |

The special subframe may include a downlink pilot time slot (DwPTS), a guard period (GP), and an uplink pilot time slot (UpPTS). DwPTS is a section for downlink resources in a special subframe and may be used for a physical downlink shared channel (PDSCH) transmission. UpPTS is a section for uplink resources in a special subframe and may be used for a sounding reference signal (SRS) or physical random access channel (PRACH) transmission. The guard period (GP) is a section in which neither downlink transmission nor uplink transmission occurs, and may be a section required for downlink-uplink switching. The guard period (GP) may be a section located between DwPTS and UpPTS in one special subframe (e.g., 1 ms). Here, a combination of DwPTS, guard period, and UpPTS included in one special subframe is referred to as a special subframe configuration (SSF configuration). Different SSF configurations indicate different combinations of the length of DwPTS, the length of the guard period, and the length of UpPTS in one frame. When a wireless communication environment supports LTE-TDD scheme, the SSF configuration may be operated as shown in Table 2 below. For example, SSF configuration #5 may indicate a combination in which DwPTS occupies 3 symbols, guard period occupies 9 symbols, and UpPTS occupies 2 symbols, and SSF configuration #7 may indicate a combination in which DwPTS occupies 10 symbols, guard period occupies 2 symbols, and UpPTS occupies 2 symbols.

[Table 2]

| SSF configuration | Symbol number | | | | | | | | | | | | | |
|---|---|---|---|---|---|---|---|---|---|---|---|---|---|---|
| | 0 | 1 | 2 | 3 | 4 | 5 | 6 | 7 | 8 | 9 | 10 | 11 | 12 | 13 |
| 0 | Dw | | | GP | | | | | | | | | | Up |
| 1 | Dw | | | | | | | | | GP | | | | Up |
| 2 | Dw | | | | | | | | | | GP | | | Up |
| 3 | Dw | | | | | | | | | | | GP | | Up |
| 4 | Dw | | | | | | | | | | | | GP | Up |
| 5 | Dw | | | GP | | | | | | | | | Up | |
| 6 | Dw | | | | | | | | | GP | | | Up | |
| 7 | Dw | | | | | | | | | | GP | | Up | |
| 8 | Dw | | | | | | | | | | | GP | Up | |
| 9 | Dw | | | | | | GP | | | | | | Up | |

According to an embodiment, the base station 110 and the terminal 120 may use a TDD scheme of NR. The TDD scheme of the NR may be configured to be more flexible than the TDD scheme of LTE. The TDD scheme of the NR defines a DL-UL pattern indicating a relationship between a DL time resource for downlink communication and a UL time resource for uplink communication. The DL-UL pattern may include a configuration periodicity, a DL time interval, and a UL time interval. The configuration periodicity may refer to a time to which one DL-UL pattern is applied. The configuration periodicity may be one of 0.5 ms, 0.625 ms, 1 ms, 1.25 ms, 2.5 ms, 3 ms, 4 ms, 5 ms, and 10 m. The DL time interval may be a time resource in which a downlink communication is continued. The DL time interval may be represented as the number of slots, the number of slots and the number of symbols, or only the number of symbols. The DL time interval may be located at a beginning part within one configuration periodicity. The UL time interval may be a time resource in which an uplink is continued. The UL time interval may be represented as the number of slots, the number of slots and the number of symbols, or only the number of symbols. The UL time interval may be located at an end part within one configuration periodicity. Slots other than a DL slot (slot in which all symbols are DL symbols) and a UL slot (slot in which all symbols are UL symbols) in one configuration periodicity may be flexible slots. A downlink symbol, an uplink symbol, and a flexible symbol may be distinguished from each other even in symbols (e.g., 14 symbols) in the slot. As an example of a resource structure of an NR TDD, when subcarrier spacing (SCS) is 15 kHz, five slots may be defined during a configuration periodicity of 5 ms. Among the five slots, the first two slots may be downlink slots, the last two slots may be uplink slots, and the middle slot may have both an uplink symbol and a downlink symbol. Among the 14 symbols of the remaining slot, the first 5 symbols may be downlink symbols, the last 3 symbols of the 14 symbols may be uplink symbols, and the remaining 6 symbols of the 14 symbols may be flexible symbols.

Since the same carrier frequency is used for uplink transmission and downlink transmission in the TDD scheme, it is necessary to distinguish between the DL time interval and the UL time interval. Therefore, as described above, resource structures for the TDD scheme may include the DL time interval and the UL time interval, and a remaining period between the DL time interval and the UL time interval. For example, a transmitting path may be used in the DL time interval in which the base station 110 transmits a signal, but a receiving path may not be used in the UL time interval in which the base station 110 receives a signal instead of the transmission path.

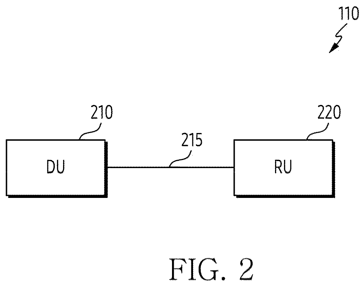

FIG. 2 illustrates an example of a base station. In FIG. 2, a DU and an RU in which functions of a base station are divided and implemented by different entities are described. For communication between the DU and the RU, a fronthaul interface may be used. Unlike a backhaul between a base station and a core network, the fronthaul refers to a section between entities between a radio access network (RAN) and a base station. FIG. 2 illustrates an example of a fronthaul architecture between one DU 210 and one RU 220, but this is only for convenience of explanation and the present disclosure is not limited thereto. In other words, the embodiments of the present disclosure may also be applied to a fronthaul architecture between one DU and a plurality of RU. For example, the embodiments of the present disclosure may be applied to a fronthaul architecture between one DU and two RU. In addition, the embodiments of the present disclosure may also be applied to a fronthaul architecture between one DU and three RU.

Referring to FIG. 2, the base station 110 may include a DU 210 and an RU 220. A fronthaul 215 between the DU 210 and the RU 220 may be operated via an Fx interface. For operation of the fronthaul 215, an interface such as an enhanced common public radio interface (eCPRI) or radio over ethernet (ROE) may be used.

As communication technology has been developed, mobile data traffic increased, and thus the bandwidth demand required in a fronthaul between a digital unit and a radio unit has increased significantly. In a deployment such as centralized/cloud radio access network (C-RAN), the DU may be implemented to perform functions for packet data convergence protocol (PDCP), radio link control (RLC), media access control (MAC), and physical (PHY), and the RU may be implemented to further perform functions for PHY layer in addition to a radio frequency (RF) function.

The DU 210 may be in charge of upper layer functions of a wireless network. For example, the DU 210 may perform functions of the MAC layer and a part of the PHY layer. Herein, a part of the PHY layer is a function performed at a higher level among the functions of the PHY layer, and may include, for example, channel encoding (or channel decoding), scrambling (or descrambling), modulation (or demodulation), and layer mapping (or layer demapping). According to an embodiment, if the DU 210 complies with an O-RAN standard, it may be referred to as an O-RAN DU (O-DU). The DU 210 may be replaced with and represented as a first network entity for a base station (e.g., gNB) in embodiments of the present disclosure, as needed.

The RU 220 may be in charge of lower layer functions of a wireless network. For example, the RU 220 may perform a part of the PHY layer, and a RF function. Herein, a part of the PHY layer is a function performed at performed at a relatively lower level than the DU 210 among the functions of the PHY layer, and may include, for example, iFFT conversion (or FFT conversion), cyclic prefix (CP) insertion (or CP removal), and digital beamforming. The RU 220 may be referred to as access unit (AU), access point (AP), transmission/reception point (TRP), remote radio head (RRH), radio unit (RU), or other terms having equivalent technical meanings. According to an embodiment, if the RU 220 complies with the O-RAN standard, it may be referred to as an O-RAN RU (O-RU). The RU 220 may be replaced with and represented as a second network entity for a base station (e.g., gNB) in embodiments of the present disclosure, as needed.

Although FIG. 2 describes that the base station 110 includes the DU 210 and the RU 220, the embodiments of the present disclosure are not limited thereto. The base station according to the embodiments may be implemented in a distributed deployment according to a centralized unit (CU) configured to perform functions of upper layers (e.g., packet data convergence protocol (PDCP), radio resource control (RRC)) of an access network and a distributed unit (DU) configured to perform functions of lower layers. As an example, the distributed unit (DU) may include the digital unit (DU) and the radio unit (RU) of FIG. 2. In addition, as an example, between a core (e.g., 5G core (5GC) or next generation core (NGC)) network and a radio access network (RAN), the base station may be implemented in an architecture in which CU, DU, and RU are arranged in order. An interface between the CU and the distributed unit (DU) may be referred to as an F1 interface.

A centralized unit (CU) may be in charge of functions of a higher layer than the DU, by being connected to one or more DUs. For example, the CU may be in charge of radio resource control (RRC) and a function of a packet data convergence protocol (PDCP) layer, and the DU and the RU may be in charge of functions of lower layers. The DU may perform radio link control (RLC), media access control (MAC), and some functions (high PHY) of PHY layer, and the RU may perform remaining functions (low PHY) of the PHY layer. In addition, as an example, a digital unit (DU) may be included in a distributed unit (DU) according to the implementation of distributed deployment of the base station. Hereinafter, unless otherwise defined, it is described as operations of the digital unit (DU) and the RU, but various embodiments of the present disclosure may be applied to both of a base station arrangement including the CU or an arrangement where the DU is directly connected to a core network (i.e., the CU and the DU are integrated into a base station (e.g., NG-RAN node) which is a single entity).

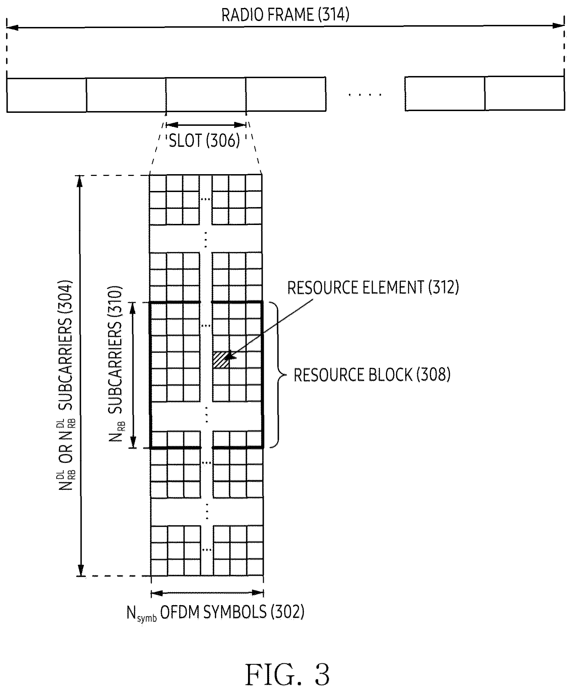

FIG. 3 illustrates an example of a resource structure in a time domain and a frequency domain. FIG. 3 illustrates a basic structure of a time-frequency domain, which is a radio resource domain in which data or a control channel is transmitted in downlink or uplink.

Referring to FIG. 3, a horizontal axis indicates the time domain and a vertical axis indicates the frequency domain. A minimum transmission unit in the time domain is an orthogonal frequency division multiplexing (OFDM) symbol, and Nsymb OFDM symbols 302 are gathered to form one slot 306. A length of a subframe is defined as 1.0 ms, and a length of a radio frame 314 is defined as 10 ms. A minimum transmission unit in the frequency domain is a subcarrier, and a carrier bandwidth configuring a resource grid may be configured with NBW subcarriers 304.

A basic unit of a resource in the time-frequency domain is a resource element (hereinafter referred to as 'RE') 312, and may be indicated as an OFDM symbol index and a subcarrier index. A resource block may include a plurality of resource elements. In an LTE system, a resource block (RB) (or a physical resource block, hereinafter 'PRB') is defined as Nsymb consecutive OFDM symbols in the time domain and NSCRB consecutive subcarriers in the frequency domain. In an NR system, a resource block (RB) 308 may be defined as NSCRB consecutive subcarriers 310 in the frequency domain. One RB 308 includes NSCRB REs 312 on a frequency axis. In general, a minimum unit of transmission of data is RB and the number of subcarriers is NSCRB=12. The frequency domain may include common resource blocks (CRB). A physical resource block (PRB) may be defined in a bandwidth part (BWP) on the frequency domain. The CRB and PRB numbers may be determined according to a subcarrier spacing. A data rate may increase in proportion to the number of RBs scheduled for a terminal.

In the NR system, a downlink transmission bandwidth and an uplink transmission bandwidth may be different in a case of a frequency division duplex (FDD) system that operates by dividing the downlink and the uplink by a frequency. A channel bandwidth indicates a radio frequency (RF) bandwidth corresponding to a system transmission bandwidth. Table 3 indicates a portion of a correspondence among a system transmission bandwidth, a subcarrier spacing (SCS) and a channel bandwidth defined in the NR system in a frequency band (e.g., a frequency range (FR) 1 (310 MHz to 7125 MHz)) lower than x GHz. Table 4 indicates a portion of a correspondence among a transmission bandwidth, a subcarrier spacing, and a channel bandwidth defined in the NR system in a frequency band (e.g., FR2 (24250 MHz - 52600 MHz) or FR2-2 (52600 MHz to 71,000 MHz)) higher than yGHz. For example, in an NR system having a channel bandwidth of 100 MHz with a subcarrier spacing of 30 kHz, a transmission bandwidth is configured with 273 RBs. In Table 3 and Table 4, N/A may be a bandwidth-subcarrier combination that is not supported in the NR system.

[Table 3]

| Channel Bandwidth [MHz] | SCS | 5 | 10 | 20 | 50 | 80 | 100 |
|---|---|---|---|---|---|---|---|
| Transmission Bandwidth Configuration $N_{RB}$ | 15kHz | 25 | 52 | 106 | 207 | N/A | N/A |
| | 30kHz | 11 | 24 | 51 | 133 | 217 | 273 |
| | 60kHz | N/A | 11 | 24 | 65 | 107 | 135 |

[Table 4]

| Channel Bandwidth [MHz] | SCS | 50 | 100 | 200 | 400 |
|---|---|---|---|---|---|
| Transmission Bandwidth Configuration NRB | 60kHz | 66 | 132 | 264 | N/A |
| | 120kHz | 32 | 66 | 132 | 264 |

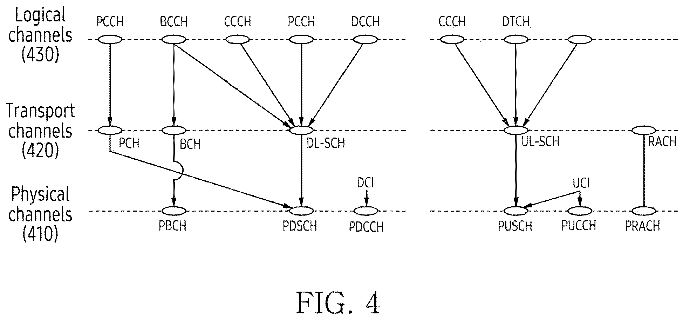

FIG. 4 illustrates an example of channels in a communication standard.

The channels may include a physical channel 410, a transport channel 420, and a logical channel 430 according to layers defined in the communication standard.

Referring to FIG. 4, the physical channel 410 may provide functions (e.g., channel coding, HARQ processing, modulation, multi-antenna processing, and resource mapping) that are necessary to generate physical signals in a physical layer. In the physical layer, the physical signals are modulated in an OFDM scheme and may be transmitted in a wireless environment via a time-frequency resource (e.g., the resource of the resource grid of FIG. 3).

In downlink transmission, the physical channel 410 may include at least one of a physical broadcast channel (PBCH), a physical downlink shared channel (PDSCH), or a physical downlink control channel (PDCCH). The PDCCH may be used to carry downlink control information (DCI). In general, downlink data may refer to symbols transmitted through the PDSCH, and a downlink control signal may include symbols transmitted through the PDCCH. In addition, in a downlink, an SS/PBCH block including a synchronization signal (e.g., a primary synchronization signal (PSS), or a secondary synchronization signal (SSS)) for synchronization and a broadcast signal (e.g., PBCH) may be transmitted in addition to channels illustrated in FIG. 4. In addition, in the downlink, a channel state information-reference signal (CSI-RS) for obtaining measurement or channel information, a demodulation reference signal (DMRS) for channel estimation and demodulation, and a phase tracking reference signal (PTRS) may be transmitted.

In uplink transmission, the physical channel 410 may include at least one of a physical uplink shared channel (PUSCH), a physical uplink control channel (PUCCH), or a physical random access channel (PRACH). The PUSCH or the PUCCH may be used to carry uplink control information (UCI). In general, uplink data may refer to symbols transmitted through the PUSCH, and an uplink control signal may refer to symbols corresponding to the UCI. For example, the UCI may include at least one of a scheduling request (SR), a hybrid automatic request (HARQ)-acknowledge (ACK) bit(s), or channel state information (CSI). In addition, in uplink, the DMRS for channel estimation and demodulation, and the PTRS may be transmitted for the channel estimation, in addition to the channels illustrated in FIG. 4.

The transport channel 420 may connect a physical layer and a medium access channel (MAC) layer located at a higher level of the physical layer, and may be classified according to how data is transmitted through a wireless interface. In the downlink, the transport channel 420 may include at least one of a paging channel (PCH) for paging, a broadcast channel (BCH) for broadcasting system information, and a downlink shared channel (DL-SCH) transmission of downlink data. In the uplink, the transport channel 420 may include at least one of a random access channel (RACH) for transmission of a random access preamble or an uplink shared channel (UL-SCH) for transmission of downlink data.

The logical channel 430 is located above the transport channel and is mapped to the transport channel 420. The logical channel 430 may be classified into a control channel for transmitting control area information and a traffic channel for transmitting user area information. The control channel of the logical channel 430 may include at least one of a paging control channel (PCCH), a broadcast control channel (BCCH), a common control channel (CCCH), or a dedicated control channel (DCCH). The traffic channel of the logical channel 430 may include a dedicated traffic channel (DTCH).

In describing embodiments of the present disclosure, a random access signal may include sequences transmitted through a physical random access channel (PRACH). 'data' may include signals other than a reference signal. For example, 'data' obtained by a receiver in uplink communication may include signals transmitted through the PUSCH. However, the PUSCH is an example, and it is certain that the embodiments of the present disclosure may be applied to other channels (e.g., PDSCH, PBCH, PDCCH, and PUCCH) that require channel estimation.

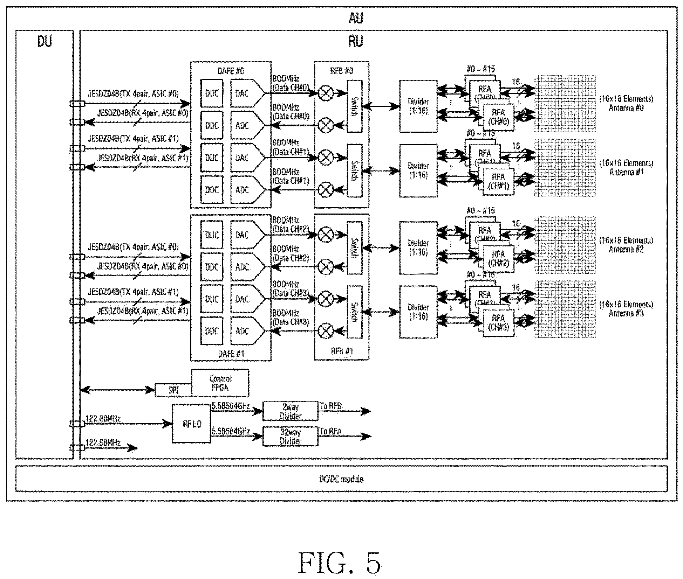

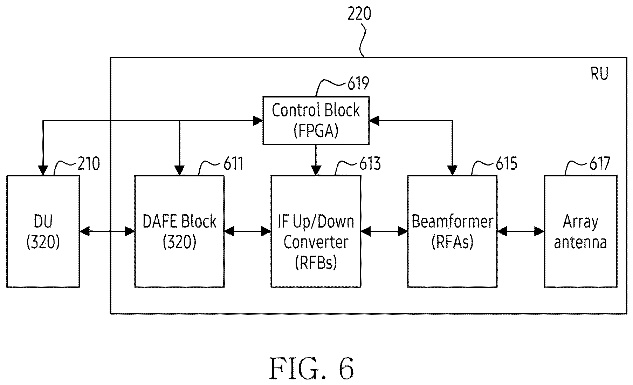

FIGS. 5 and 6 illustrate an example of a functional configuration of an electronic device according to embodiments of the present disclosure. The electronic device (e.g., the base station 110) may include an access unit. The access unit may include an RU 220, a DU 210, and a DC/DC module. The RU 220 according to embodiments of the present disclosure may mean an assembly in which antennas and RF components are mounted. The DU 210 according to embodiments of the present disclosure may be configured to process a digital wireless signal, encrypt a digital wireless signal to be transmitted to the RU 220, or decode a digital wireless signal received from the RU 220. The DU 210 may be configured to communicate with an upper node (e.g., a centralized unit (CU)) or a core network (e.g., 5GC, EPC) by processing packet data.

Referring to FIG. 5, the RU 220 may include a plurality of antenna elements. The RU 220 may include one or more array antennas. According to an embodiment, the array antenna may be configured with a planar antenna array. The array antenna may correspond to one stream. The array antenna may include a plurality of antenna elements corresponding to one transmitting path (or receiving path). For example, the array antenna may include 256 antenna elements configured with $16\times16$.

The RU 220 may include RF chains for processing a signal of each array antenna. The RF chains may be referred to as 'RFA'. The RFA may include RF components (e.g., phase shifter, power amplifier) for beamforming and a mixer. The mixer of the RFA may be configured to downconvert an RF signal of an RF frequency into an intermediate frequency or up-convert a signal of intermediate frequency into a signal of an RF frequency. According to an embodiment, one set of RF chains may correspond to one array antenna. As an example, the RU 220 may include four RF chain sets for four array antennas. A plurality of RF chains may be connected to a transmitting path or a receiving path through a divider (e.g., 1:16). Although not illustrated in FIG. 5, according to an embodiment, RF chains may be implemented as a radio frequency integrated circuit (RFIC). The RFIC may process and generate RF signals supplied to a plurality of antenna elements.

The RU 220 may include a digital analog front end (DAFE) and RFB. The DAFE may be configured to convert a digital signal and an analog signal to each other. As an example, the RU 220 may include two DAFEs (DAFE #0 and DAFE #1). The DAFE may be configured to upconvert a digital signal (i.e., DUC) in a transmitting path and convert the up-converted signal into an analog signal (i.e., DAC). In a receiving path, the DAFE may be configured to convert an analog signal to a digital signal (i.e., ADC) and down-convert a digital signal (i.e., DDC). The RFB may include a mixer and a switch corresponding to a transmitting path and a receiving path. The mixer of RFB may be configured to upconvert a baseband frequency to an intermediate frequency or downconvert a signal of intermediate frequency to a signal of the baseband frequency. The switch may be configured to select one of a transmitting path and a receiving path. As an example, the RU 220 may include two RFBs (RFB #0 and RFB #1).

The RU 220 is a controller and may include a field programmable gate array (FPGA). The FPGA refers to a semiconductor device including a designable logic element and a programmable internal circuit. It may perform communication with the DU 210 through serial peripheral interface (SPI) communication.

The RU 220 may include an RF local oscillator (LO). The RF LO may be configured to supply a reference frequency for up-conversion or down-conversion. According to an embodiment, the RF LO may be configured to provide a frequency for up-conversion or down-conversion of the above-described RFB. For example, the RF LO may supply a reference frequency to RFB #0 and RFB #1 through a 2-way divider.

According to an embodiment, the RF LO may be configured to provide a frequency for up-conversion or down-conversion of the above-described RFA. For example, the RF LO may supply a reference frequency to each of RFAs (8 for each RF chain, per polarization group) through a 32-way divider.

Referring to FIG. 6, the RU 220 may include a DAFE block 611, an IF up/down converter 613, a beamformer 615, an array antenna 617, and a control block 619. The DAFE block 611 may convert a digital signal into an analog signal or convert an analog signal into a digital signal. The IF up/down converter 613 may correspond to the RFB. The IF up/down converter 613 may convert a signal of a baseband frequency into a signal of an IF frequency, or may convert a signal of an IF frequency into a signal of a baseband frequency, based on the reference frequency supplied from the RF LO. The beamformer 615 may correspond to the RFA. The beamformer 615 may convert a signal of an RF frequency to a signal of an IF frequency, or may convert a signal of an IF frequency to a signal of an RF frequency, based on the reference frequency supplied from the RF LO. The array antenna 617 may include a plurality of antenna elements. Each antenna element of the array antenna 617 may be configured to radiate a signal processed through the RFA. The array antenna 617 may be configured to perform beamforming according to a phase applied by the RFA. The control block 619 may control each block of the RU 220 to perform a command from the DU 210 and the above-described signal processing.

Although the base station 110 is illustrated in FIGS. 1A to 6, embodiments of the present disclosure are not limited to the base station 110. The embodiments of the present disclosure may be applied not only to a base station including the DU and the RU, but also to an electronic device for radiating a wireless signal.

In the following specification, calibration circuitry for calibrating an ADC, and an electronic device for determining whether there is an anomaly in a transmitting path and a receiving path will be described. An electronic device (e.g., the electronic device 700) described below may be an example of the above-described RU 220.

According to an embodiment, as a frequency band used in A6G (above 6 GHz) band increases, a band for an intermediate frequency (IF) may be set to 6 GHz. Accordingly, in an electronic device (e.g., receiver or the RU 220) to implement an analogue to digital converter (ADC) (or ADC circuit) for receiving a high intermediate frequency, an interleaving ADC (or time-interleaving ADC) may be used. For example, the interleaving ADC may be configured with a plurality of ADCs. As the plurality of ADCs are used, calibration for skew, offset, and/or gain of each of the plurality of ADCs should be performed. An operation for calibration for skew, offset, and/or gain of each of the plurality of ADCs may be implemented based on hardware intellectual property (IP). Hardware IP refers to a functional block and/or circuitry for performing a specified operation.

For example, when the intermediate frequency is set to a high frequency (e.g., 6 GHz) in a transceiver, an intermediate frequency set to a high frequency may be inputted to the ADC. An interleaving ADC may be used as the ADC. When the interleaving ADC is used, an ADC calibration process should be performed due to a mismatch of skew, offset, and/or gain. A signal on which the ADC calibration process has been performed may be transmitted to digital down converter (DDC) circuitry of the electronic device. For example, the ADC calibration process may be performed based on one of a foreground calibration scheme and a background calibration scheme. For example, an electronic device (or processor of the electronic device) may perform an ADC calibration process based on a foreground calibration scheme by inputting a reference signal into the ADC.

An electronic device including conventional RF circuitry is incapable of monitoring a signal on which the ADC calibration process has been performed. For example, the electronic device including conventional RF circuitry is incapable of identifying whether circuitry for the ADC calibration process is normal and identifying the performance of the circuitry for the ADC calibration process. When the circuitry for the ADC calibration process operates abnormally, a normal service cannot be provided. RF circuitry for solving the above problem will be described below.

In the following specification, an electronic device for performing an ADC calibration process based on a foreground calibration scheme will be described. For example, the electronic device may identify whether an ADC calibration process (or circuitry for the ADC calibration process) is normal and whether spur performance is normal, by using a reference signal. The electronic device may determine whether a problem occurs in circuitry for an intermediate frequency band in hardware. Therefore, the electronic device (or system related to the electronic device) may monitor the status of circuits included in the electronic device and provide an alarm when a problem occurs in the circuits.

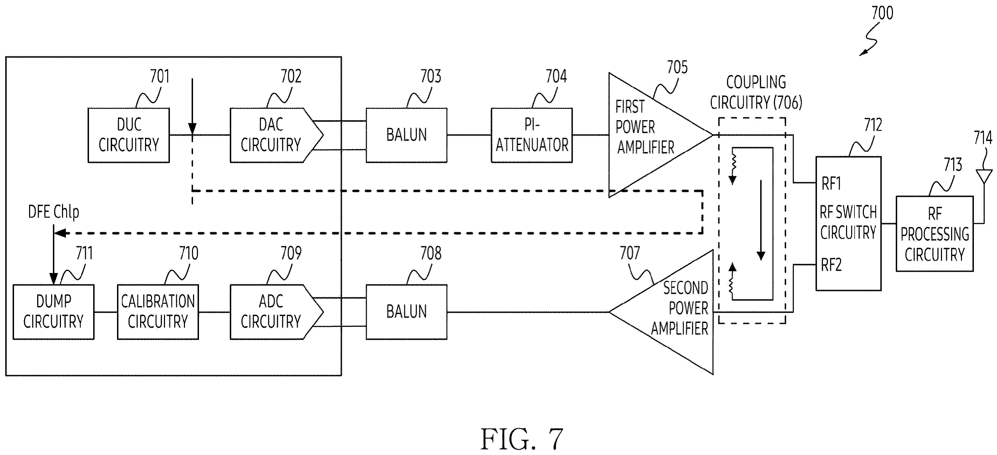

FIG. 7 illustrates an example of RF circuitry for an ADC calibration process included in an electronic device.

Referring to FIG. 7, an electronic device 700 may include at least one of a digital up converter (DUC) 701, a digital to analogue converter (DAC) 702, a balun 703, a pi-attenuator 704, a first power amplifier 705, coupling circuitry 706, a second power amplifier 707, a balun 708, an analog to digital converter 709, calibration circuitry 710, dump circuitry 711, RF switch circuitry 712, RF processing circuitry 713, and an antenna 714. For example, at least a part of the DUC 701, the DAC 702, the balun 703, the pi-attenuator 704, the first power amplifier 705, the coupling circuitry 706, the second power amplifier 707, the balun 708, the ADC 709, the calibration circuitry 710, the dump circuitry 711, the RF switch circuitry 712, the RF processing circuitry 713, and the antenna 714 may be omitted according to embodiments.

For example, the balun 703 may be used to convert a single signal into a differential signal. The pi-attenuator 704 may be used to lower a signal level. The first power amplifier 7045 may be used to amplify a transmitted signal. The coupling circuitry 710 may be used to configure a loopback path between a transmitting path and a receiving path. The calibration circuitry 710 may be used for an ADC calibration process. The dump circuitry 711 may be used to obtain (e.g., capture) a signal outputted through the calibration circuitry 710. The RF switch circuitry 712 may be used to receive or transmit a signal, based on TDD. The RF processing circuitry 713 may be used to process a signal of an antenna (e.g., array antenna). As an example, the RF processing circuitry 713 may include RFA.

For example, the DUC 701, the DAC 702, the ADC 709, the calibration circuitry 710, and the dump circuitry 711 may be configured with digital frontend (DFE) circuitry.

According to an embodiment, the electronic device 700 may transmit a signal using a transmitting path. For example, the transmitting path may include at least a portion of the DUC 701, the DAC 702, the balun 703, the pi-attenuator 704, the first power amplifier 705, the RF switch circuitry 712, the RF processing circuitry 713, and the antenna 714. For example, the transmitting path may be used to receive a signal regarding the intermediate frequency. For example, the transmitting path may include the DUC 701, the DAC 702, the balun 703, the pi-attenuator 704, and the first power amplifier 705.

According to an embodiment, the electronic device 700 may receive a signal using a receiving path. For example, the receiving path may include at least a portion of the antenna 714, the RF processing circuitry 713, the RF switch circuitry 712, the second power amplifier 707, the balun 708, the ADC 709, and the calibration circuitry 710. For example, the receiving path may be used to receive a signal regarding the intermediate frequency. For example, the receiving path may include the second power amplifier 707, the balun 708, and the ADC 709.

According to an embodiment, the electronic device 700 may activate one of the transmitting path and the receiving path in a first mode (or a communication mode). The electronic device 700 may perform communication based on TDD, by activating one of the transmitting path and the receiving path. For example, the first mode may mean a mode in which one of the transmitting path and the receiving path is connected to the RF processing circuitry 713. For example, the electronic device 700 may activate the transmitting path, based on activating the first power amplifier 705. The electronic device 700 may activate the receiving path based on activating the second power amplifier 707.

The electronic device 700 may activate both the transmitting path and the receiving path in a second mode (or a calibration mode). The electronic device 700 may perform the ADC calibration process by activating both the transmitting path and the receiving path. For example, the second mode may refer to a mode in which the RF processing circuitry 713 is controlled to be in an idle state and the first power amplifier 705 and the second power amplifier 707 are activated. For example, in the second mode, the electronic device 700 may control the RF processing circuitry 713 to be in the idle state and may activate the first power amplifier 705 and the second power amplifier 707.

For example, the electronic device 700 may generate a reference signal (e.g., a continuous wave (CW) signal). The electronic device 700 may input the reference signal in a path between the DUC 701 and the DAC 702. The reference signal may be looped back through the transmitting path and the receiving path. The electronic device 700 may identify a target signal changed from the reference signal between the ADC 709 and the calibration circuitry 710. The electronic device 700 may obtain a calibration signal changed from the target signal through the calibration circuitry 710. The electronic device 700 may identify whether there is anomaly of at least one of the calibration circuitry 710, the transmitting path, and the receiving path (e.g., a failure of the calibration circuitry 710), based on the reference signal and the calibration signal. Hereinafter, an operation of the electronic device 700 for the ADC calibration process will be described.

FIG. 7 illustrates a portion of RF circuitry of the electronic device 700, but is not limited thereto. According to an embodiment, the electronic device 700 may include at least a portion or all of components included in the RU 220 illustrated in FIG. 5. For example, the electronic device 700 may include an array antenna including a plurality of antennas, RF processing circuits coupled to the array antenna (e.g., RFA or RF processing circuitry 713), and RF switches connected to RF processing circuits (e.g., switch of RFB or RF switch 712). For example, among coupling circuits, each coupling circuitry (e.g., coupling circuitry 706) may be configured to connect a transmitting path for signal transmission and a receiving path for signal reception. The transmitting path may be configured through DAC circuitry (e.g., the DAC 702) and first power amplifier circuitry (e.g., the first power amplifier 705). The receiving path may be configured through second power amplifier circuitry (e.g., the second power amplifier 707) and ADC circuitry (e.g., the ADC 709).

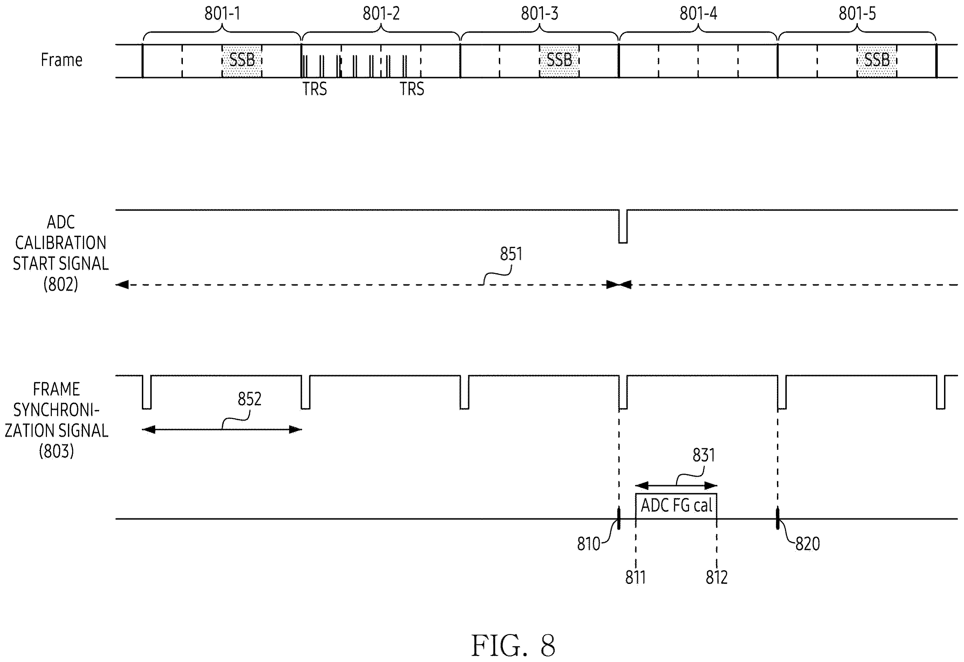

FIG. 8 illustrates an example of a timing diagram of signals for ADC calibration.

Referring to FIG. 8, an electronic device 700 (e.g., processor of the electronic device 700) may transmit at least one frame (or radio frame) (e.g., signal 801-1 to signal 801-5). For example, one frame may be transmitted based on a frame synchronization signal 803. The electronic device 700 may transmit a frame based on the frame synchronization signal 803. The frame synchronization signal 803 may operate based on a period 852. As an example, the period 852 of the frame synchronization signal 803 may be set to 10 milliseconds [msec]. As the period 852 of the frame synchronization signal 803 is set to 10 [msec], a length of one frame may be set to 10 [msec].

The electronic device 700 may operate in a second mode, based on the ADC calibration start signal 802 to the frame synchronization signal 803. For example, the electronic device 700 (e.g., the processor of the electronic device 700) may identify a command for changing a mode of the electronic device 700 from the first mode to the second mode through software for RF. As an example, the electronic device 700 may identify a command for changing the mode of the electronic device 700 from the first mode to the second mode based on an input. As an example, the electronic device 700 may identify a command for changing the mode of the electronic device 700 from the first mode to the second mode based on a specified time interval (or a specified period).

For example, the ADC calibration start signal 802 may be generated based on a period 851. The period 851 may be set to one of 40 [msec], 80 [msec], and 160 [msec]. The period 851 may mean a period in which the mode of the electronic device 700 is changed to the second mode.

Based on identifying a command for changing the mode of the electronic device 700 from the first mode to the second mode, the electronic device 700 may perform an operation for changing the mode of the electronic device 700 from the first mode to the second mode at a time point 810. For example, the electronic device 700 may perform an operation for changing the mode of the electronic device 700 from the first mode to the second mode at the time point 810, which is a time point when a value of the ADC calibration start signal 802 is changed.

As an example, at the time point 810, the electronic device 700 may change the RF processing circuitry 713 to an idle state. The electronic device 700 may set the first power amplifier 705 operating based on TDD to remain in an active state. In the first mode, the first power amplifier 705 may be active for a signal transmission period set based on the TDD. The first power amplifier 705 may be deactivated for a signal reception period set based on the TDD. On the other hand, in the second mode, the first power amplifier 705 may remain in the active state.

The electronic device 700 may operate the calibration circuitry 710 after the RF processing circuitry 713 is changed to the idle state and the first power amplifier 705 is maintained in the active state. As an example, the electronic device 700 may operate the calibration circuitry 710 included in digital frontend (DFE) circuitry. After the RF processing circuitry 713 is changed to the idle state and the first power amplifier 705 is maintained in the active state, the electronic device 700 may operate in the second mode at a time point 811. The electronic device 700 may perform an operation for changing the mode of the electronic device 700 from the first mode to the second mode at the time point 810, and may operate in the second mode at the time point 811. In the second mode, the electronic device 700 may change at least a portion (e.g., the ADC 709 and the calibration circuitry 710) of components of the electronic device 700, which operated based on the TDD, to operate based on the FDD.

The electronic device 700 may generate a reference signal (e.g., CW signal) before an input of the DAC 702. The coupling circuitry 706 may be used to provide a loopback path connecting the transmitting path and the receiving path. Accordingly, the reference signal may be transmitted to the ADC 709 through the coupling circuitry 706 configured to connect the transmitting path and the receiving path.

The electronic device 700 may identify a target signal changed from a reference signal in an output portion of the ADC 709. The reference signal may be changed into a target signal through the transmitting path, the receiving path, and the loopback path. The electronic device 700 may calibrate the target signal through the calibration circuitry 710. The target signal may be calibrated (or changed) through the calibration circuitry 710. The electronic device 700 may obtain a calibration signal based on a calibration of the target signal through the calibration circuitry 710. For example, the electronic device 700 may obtain a calibration signal by capturing the calibration signal using the dump circuitry 711.

After the calibration signal is obtained, the electronic device 700 may change at least a portion (e.g., the ADC 709, the calibration circuitry 710, the first power amplifier 705, and the RF processing circuitry 713) of components of the electronic device 700, which was operated based on the FDD according to the second mode, to operate based on the TDD. The electronic device 700 may operate in the second mode during a time interval 831 from the time point 811 to a time point 812. The electronic device 700 may operate in the second mode within the time interval 831. The electronic device 700 may operate in the first mode from the time point 810 to the time point 811. The electronic device 700 may operate in the first mode from the time point 812 to a time point 820. Although the electronic device 700 operates in the first mode from the time point 812 to the time point 820, a normal operation based on the TDD may be performed from the time point 820. As an example, the time interval 831 may be set to 6 [msec].

The electronic device 700 may identify whether the ADC calibration process is abnormal, based on the reference signal and the calibration signal. For example, based on the reference signal and the calibration signal, the electronic device 700 may identify whether there is anomaly of at least one of the calibration circuitry, the transmission path, and the receiving path (e.g., a failure of the calibration circuitry 710). The electronic device 700 may identify whether anomaly of at least one of calibration circuitry, the transmitting path, and the receiving path, based on the following equations.

For example, the electronic device 700 may identify a first ratio which is a ratio of a maximum value of a cross-correlation function between the reference signal and the calibration signal with respect to a maximum value of a cross-correlation function between the reference signal and complex conjugate of the calibration signal. The electronic device 700 may identify whether the ADC calibration process is normal, based on the first ratio. The electronic device 700 may identify whether the calibration circuitry 710 is operating normally, based on the first ratio. The first ratio may be identified based on the following equation.

[Equation 1]

$$r1 = \frac{\max\left(E[x(t)y^*(t)]\right)}{\max\left(E[x(t)y(t)]\right)}$$

Referring to Equation 1, r1 denotes a first ratio. x(t) denotes a reference signal. y(t) denotes a calibration signal. $E[x(t)y(t)]$ denotes a cross-correlation function between the reference signal and complex conjugate of the calibration signal. $E[x(t)y^*(t)]$ denotes a cross-correlation function between the reference signal and the calibration signal.

In Equation 1, the first ratio is identified as a ratio of a maximum value of a cross-correlation function between the reference signal and the calibration signal with respect to a maximum value of a cross-correlation function between the reference signal and complex conjugate of the calibration signal, but this is not limited thereto. The first ratio may also be identified as a ratio of a minimum value (or average value) of the cross-correlation function between the reference signal and the calibration signal with respect to a minimum value (or average value) of the cross-correlation function between the reference signal and the complex conjugate of the calibration signal.

For example, the electronic device 700 may identify a second ratio which is a ratio of a maximum value of a cross-correlation function between the reference signal and the calibration signal with respect to a maximum value of an auto-correlation function of the calibration signal. Based on the second ratio, the electronic device 700 may identify whether spur performance of the calibration circuitry 710 is normal. The second ratio may be identified based on the following equation.

[Equation 2]

$$r2 = \frac{\max\left(E[x(t)y^*(t)]\right)}{\max\left(E[y(t)y^*(t)]\right)}$$

Referring to Equation 2, r2 denotes a second ratio. x(t) denotes a reference signal. y(t) denotes a calibration signal. $E[y(t)y^*(t)]$ denotes an auto correlation function of the calibration signal. $E[x(t)y^*(t)]$ denotes a cross correlation function between the reference signal and the calibration signal.

The electronic device 700 may identify whether anomaly of at least one of the calibration circuitry, the transmitting path, and the receiving path, based on the first ratio and the second ratio. Whether there is anomaly of at least one of the calibration circuitry, the transmitting path, and the receiving path may be identified based on whether there is anomaly of the ADC calibration process and/or whether there is anomaly of spur performance related to the ADC calibration of the calibration circuitry 710.

The electronic device 700 may identify the anomaly of at least one of the calibration circuitry, the transmitting path, and the receiving path, based on identifying the first ratio being out of a first reference range. For example, the electronic device 700 may identify the anomaly of the ADC calibration process, based on identifying the first ratio being out of the first reference range. The electronic device 700 may identify anomaly of at least one of the calibration circuitry, the transmitting path, and the receiving path, based on identifying anomaly of the ADC calibration process.

As an example, a threshold value for the first ratio may be set to 300. The first reference range may be set to 300 or greater. The electronic device 700 may identify anomaly of the ADC calibration process, based on identifying the first ratio being less than 300. The electronic device 700 may identify that the ADC calibration process is operating normally, based on identifying that a difference between a real signal and a spur signal is 46 dB and the first ratio is 300 or greater. The electronic device 700 may identify that the ADC calibration process is operating normally, based on identifying that a difference between a real signal and a spur signal is 46 dB and the first ratio is 300 or greater. For example, the electronic device 700 may identify a defect of a hardware path for an intermediate frequency, based on identifying that the first ratio is out of the first reference range.

The electronic device 700 may identify anomaly of at least one of the calibration circuitry, the transmitting path, and the receiving path, based on identifying that the second ratio is out of a second reference range. For example, the electronic device 700 may identify an anomaly of spur performance regarding ADC calibration of the calibration circuitry 710, based on identifying that the second ratio is out of the second reference range. The electronic device 700 may identify anomaly of at least one of the calibration circuitry, the transmitting path, and the receiving path, based on identifying anomaly of spur performance regarding ADC calibration of the calibration circuitry 710.

As an example, a threshold value for the second ratio may be set to 0.5. The second reference range may be set to less than 0.5. Based on identifying that the second ratio is greater than or equal to 0.5, the electronic device 700 may identify anomaly of spur performance for ADC calibration of the calibration circuitry 710. For example, the electronic device 700 may identify that the spur performance of the ADC calibration of the calibration circuitry 710 is abnormal, based on identifying that the second ratio is greater than or equal to 0.5.

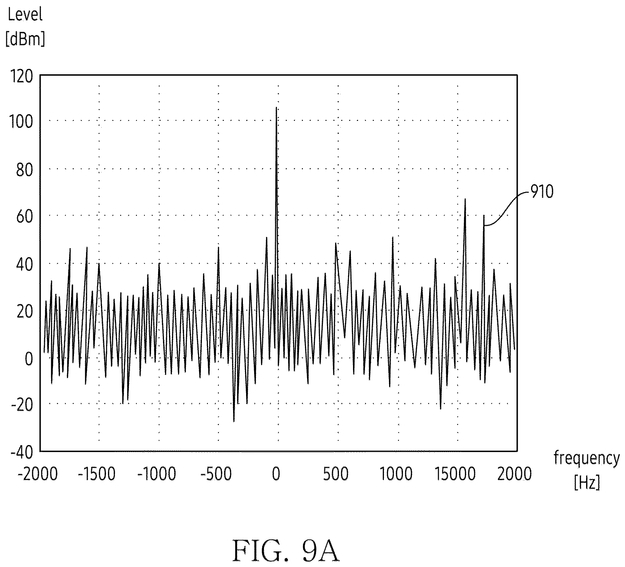

FIG. 9A illustrates an example of a calibration signal when an ADC calibration process is normal and spur performance of calibration circuitry is normal.

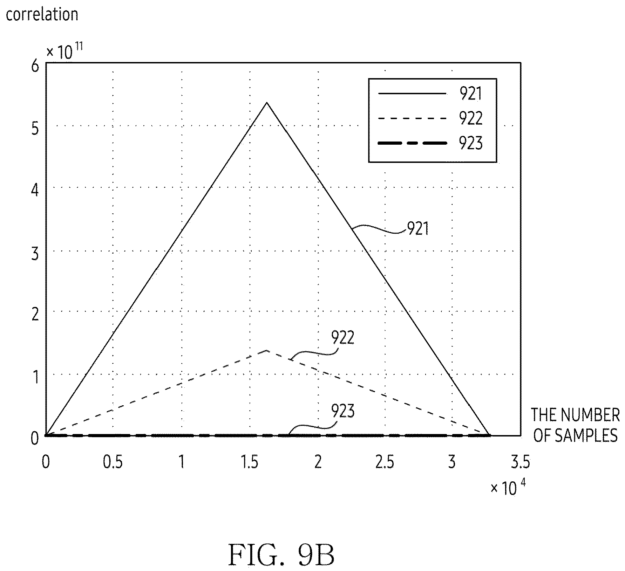

FIG. 9B illustrates an example of correlation functions when an ADC calibration process is normal and spur performance of calibration circuitry is normal.

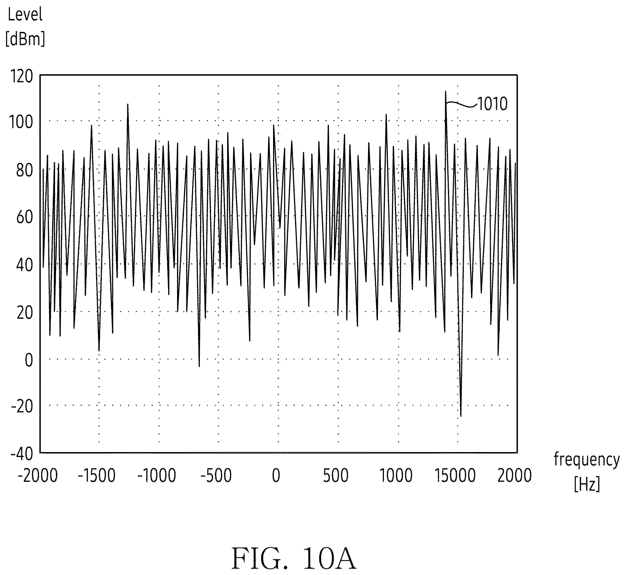

FIG. 10A illustrates an example of a calibration signal when an ADC calibration process is abnormal.

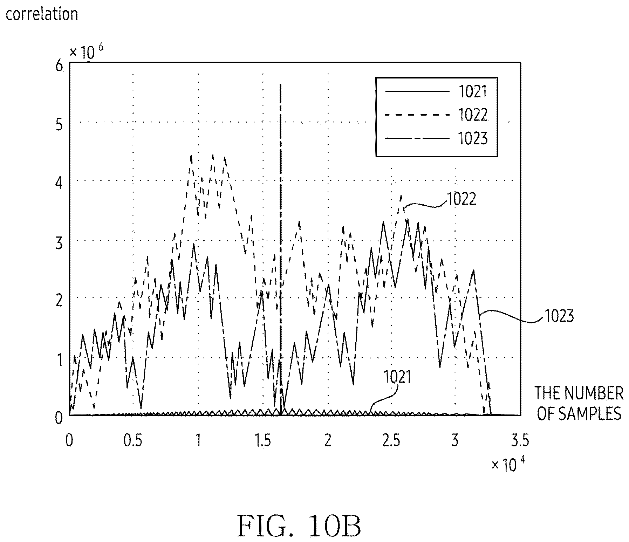

FIG. 10B illustrates an example of correlation functions when an ADC calibration process is abnormal.

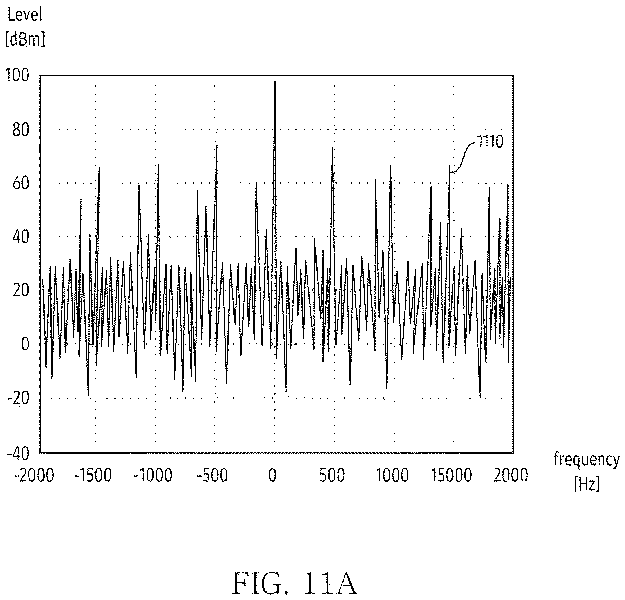

FIG. 11A illustrates an example of a calibration signal when spur performance is abnormal.

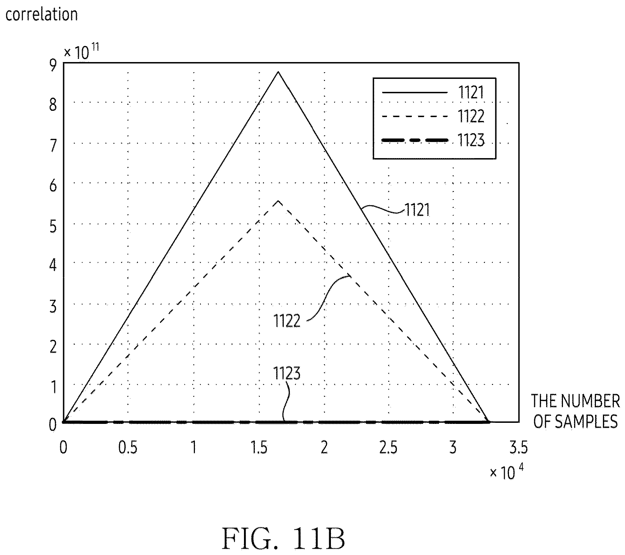

FIG. 11B illustrates an example of correlation functions when spur performance is abnormal.

Referring to FIGS. 9A and 9B, a graph 910 represents a calibration signal when the ADC calibration process is normal and the spur performance of the calibration circuitry is normal. A horizontal axis of the graph 910 represents a frequency. The unit of the horizontal axis is [Hz]. A vertical axis of the graph 910 represents a level. The unit of the vertical axis is [dBm]. A graph 921 represents an auto correlation function of the calibration signal when the ADC calibration process is normal and the spur performance of the calibration circuitry is normal. A graph 922 represents a cross correlation function between a reference signal and the calibration signal when the ADC calibration process is normal and the spur performance of the calibration circuitry is normal. A graph 923 represents a cross correlation function between the reference signal and complex conjugate of the calibration signal when the ADC calibration process is normal and the spur performance of the calibration circuitry is normal. The horizontal axis of graphs 921 to 923 represents the number of samples. The vertical axis of graphs 921 to 923 represents a value for correlation.

For example, the first ratio, which is a ratio of a maximum value of a cross correlation function (i.e., the graph 922) between the reference signal and the calibration signal, with respect to a maximum value of the cross correlation function (i.e., the graph 923) between the reference signal and the complex conjugate of the calibration signal, may be 342. The electronic device 700 may identify that the ADC calibration process is normal based on identifying that the first ratio is greater than or equal to a first threshold value (e.g., 300). The second ratio, which is a ratio of a maximum value of a cross-correlation function between the reference signal and the calibration signal with respect to a maximum value of an auto-correlation function of the calibration signal, may be 0.25. The electronic device 700 may identify that spur performance of the calibration circuitry 710 is normal, based on identifying that the second ratio is less than a second threshold value (e.g., 0.5).

Referring to FIGS. 10A and 10B, a graph 1010 represents a calibration signal when the ADC calibration process is abnormal. The horizontal axis of the graph 1010 represents a frequency. The unit of the horizontal axis is [Hz]. The vertical axis of the graph 1010 represents a level. The unit of the vertical axis is [dBm]. A graph 1021 represents an auto correlation function of the calibration signal when the ADC calibration process is abnormal. A graph 1022 represents a cross-correlation function between the reference signal and the calibration signal, when the ADC calibration process is abnormal. A graph 1023 represents a cross-correlation function between of the reference signal and complex conjugate the calibration signal when the ADC calibration process is abnormal. The horizontal axis of graphs 1021 to 1023 represents the number of samples. The vertical axis of graphs 921 to 923 represents a value for correlation.

For example, the first ratio, which is a ratio of a maximum value of a cross-correlation function (i.e., the graph 1022) between the reference signal and the calibration signal, with respect to a maximum value of a cross-correlation function (i.e., the graph 1023) between the reference signal and complex conjugate of the calibration signal, may be 1.3. The electronic device 700 may identify that the ADC calibration process is abnormal, based on identifying that the first ratio is less than a first threshold value (e.g., 300). The second ratio, which is a ratio of a maximum value of a cross-correlation function between the reference signal and the calibration signal, with respect to a maximum value of an auto-correlation function of the calibration signal, may be 0.78. The electronic device 700 may identify that spur performance of the calibration circuitry 710 is abnormal, based on identifying that the second ratio is greater than or equal to a second threshold value (e.g., 0.5). When the ADC calibration process is abnormal, the spur performance may also be identified as abnormal.

Referring to FIGS. 11A and 11B, a graph 1110 represents a calibration signal when the spur performance of the calibration circuitry 710 is abnormal. The horizontal axis of the graph 1110 represents a frequency. The unit of the horizontal axis is [Hz]. The vertical axis of the graph 1110 represents a level. The unit of the vertical axis is [dBm]. The graph 1121 represents an auto-correlation function of the calibration signal when the spur performance of the calibration circuitry 710 is abnormal. A graph 1122 represents a cross-correlation function between a reference signal and the calibration signal when the spur performance of the calibration circuitry 710 is abnormal. A graph 1123 represents a cross-correlation function between the reference signal and complex conjugate of the calibration signal when the spur performance of the calibration circuitry 710 is abnormal. The horizontal axis of graphs 1121 to 1123 represents the number of samples. The vertical axis of graphs 1121 to 1123 represents a value for correlation.

For example, the first ratio, which is a ratio of a maximum value of a cross-correlation function (i.e., the graph 1122) between the reference signal and the calibration signal with respect to a maximum value of a cross-correlation function (i.e., the graph 1123) between the reference signal and complex conjugate of the calibration signal, may be 331. The electronic device 700 may identify that the ADC calibration process is abnormal, based on identifying that the first ratio is less than a first threshold value (e.g., 300). The second ratio, which is a ratio of a maximum value of a cross-correlation function between the reference signal and the calibration signal with respect to a maximum value of an auto correlation function of the calibration signal, may be 0.78. The electronic device 700 may identify that the spur performance of the calibration circuitry 710 is abnormal, based on identifying that the second ratio is greater than or equal to a second threshold value (e.g., 0.5). When the ADC calibration process is abnormal, the spur performance may also be identified as abnormal.

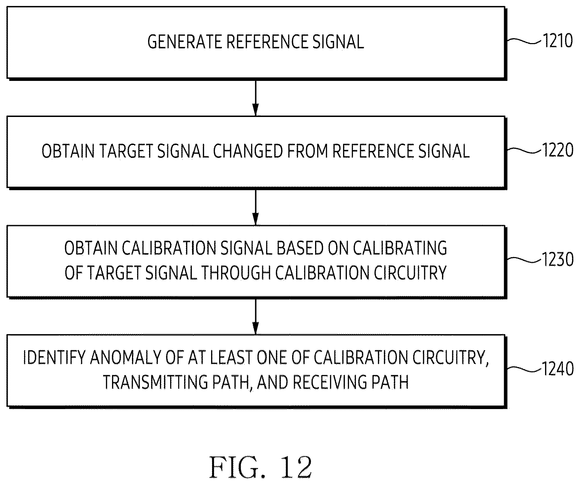

FIG. 12 is a flowchart illustrating an operation of an electronic device.

Referring to FIG. 12, in operation 1210, an electronic device (e.g., the electronic device 700) (or a processor of the electronic device) may generate a reference signal. For example, the electronic device may generate the reference signal, based on a mode of the electronic device being changed from a first mode in which one of a transmitting path and a receiving path is connected to RF processing circuitry (e.g., the RF processing circuitry 713) to a second mode in which the RF processing circuitry is controlled to be in an idle state and a first power amplifier (e.g., the first power amplifier 705) and a second power amplifier (e.g., the second power amplifier 707) are activated. For example, the reference signal may include a CW signal.

For example, the electronic device may operate in one of the first mode and the second mode. In the first mode, the electronic device may transmit and receive a signal, based on the TDD. In the second mode, the electronic device may perform an ADC calibration process.

For example, in the first mode, one of the transmitting path and the receiving path may be connected to the RF processing circuitry. In a second mode, the RF processing circuitry may operate in the idle state. In the second mode, the first power amplifier and the second power amplifier may be activated.

As an example, the transmitting path may include a path between DAC circuitry (e.g., the DAC 702) and first power amplifier circuitry. The transmitting path may be activated based on the first power amplifier being activated. The transmitting path may be deactivated based on the first power amplifier being deactivated. The receiving path may include a path between the ADC circuitry (e.g., the ADC 709) and the second power amplifier. The receiving path may be activated based on the second power amplifier being activated. The receiving path may be deactivated based on the second power amplifier being deactivated.

As an example, the ADC circuitry may include time-interleaving ADC circuitry.

As an example, the transmitting path may be used to transmit a signal related to an intermediate frequency in the first mode. The receiving path may be used in the first mode to receive a signal related to the intermediate frequency.

For example, the electronic device may identify a synchronization signal (e.g., the frame synchronization signal 803) generated based on a time period corresponding to a length (e.g., 10 [msec]) of a radio frame. The electronic device may change the mode of the electronic device from the first mode to the second mode, based on the synchronization signal. The electronic device may change the mode of the electronic device from the first mode to the second mode, based on identifiying that a value of the synchronization signal is changed.

For example, in the second mode, the ADC and the calibration circuitry may be configured to operate based on the FDD.

For example, after the mode of the electronic device is changed to the second mode, the electronic device may maintain the second mode within the length of the radio frame. The electronic device may maintain the mode of the electronic device set to the second mode within the length of the radio frame.

In operation 1220, the electronic device may obtain a target signal changed from a reference signal. For example, the electronic device may obtain the target signal changed from the reference signal through the receiving path, in response to transmitting the reference signal through the transmitting path.

For example, the reference signal may be received back to the electronic device through the transmitting path, the coupling circuitry, and the receiving path. The reference signal may be changed through the transmitting path, the coupling circuitry, and the receiving path. The electronic device 700 may obtain (or identify) the target signal changed from the reference signal by the transmitting path, the coupling circuitry, and the receiving path.

In operation 1230, the electronic device may obtain a calibration signal based on calibrating of a target signal through calibration circuitry (e.g., the calibration circuitry 710). The target signal may be changed into a calibration signal through the calibration circuitry.

For example, the electronic device may identify (or obtain) a calibration signal by using dump circuitry. The electronic device may obtain a calibration signal output through the calibration circuitry by using dump circuitry (e.g., the dump circuitry 711).

In operation 1240, the electronic device may identify anomaly of at least one of the calibration circuitry, the transmitting path, and the receiving path. For example, based on the reference signal and the calibration signal, the electronic device may identify anomaly of at least one of the calibration circuitry, the transmission path, and the receiving path.

For example, based on identifying of anomaly of the ADC calibration process and/or anomaly of spur performance of the calibration circuit, the electronic device may identify anomaly of at least one of the calibration circuitry, the transmitting path, and the receiving path.

For example, the electronic device may identify a first ratio, which is a ratio of a maximum value of a cross-correlation function between the reference signal and the calibration signal, with respect to a maximum value of a cross-correlation function between the reference signal and complex conjugate of the calibration signal. For example, the electronic device may identify the first ratio based on Equation 1. As an example, the electronic device may identify a second ratio, which is a ratio of a maximum value of a cross-correlation function between the reference signal and the calibration signal, with respect to a maximum value of an auto correlation function of the calibration signal. As an example, the electronic device 700 may identify the second ratio based on Equation 2.

The electronic device may identify anomaly of at least one of the calibration circuitry, the transmitting path, and the receiving path, based on identifying that the first ratio is out of a first reference range or the second ratio is out of a second reference range distinguished from the first reference range. As an example, the electronic device may identify anomaly of the ADC calibration process, based on the first ratio being out of the first reference range. As an example, the electronic device may identify anomaly of spur performance of the calibration circuitry, based on the second ratio being out of the second reference range.

According to an embodiment, the electronic device may identify anomaly of at least one of the calibration circuitry, the transmitting path, and the receiving path, based on identifying whether the first ratio is out of the first reference range. When the first ratio is within the first reference range, the electronic device may identify anomaly of at least one of the calibration circuitry, the transmitting path, and the receiving path, based on identifying whether the second ratio is out of the second reference range. For example, in order to identify anomaly of at least one of the calibration circuitry, the transmitting path, and the receiving path, the electronic device may first identify whether the first ratio is within the first reference range and secondly identify whether the second ratio is within the second reference range.

According to an embodiment, the electronic device may identify that the calibration circuitry, the transmitting path, and the receiving path are normal, based on identifying that the first ratio is within the first reference range and the second ratio is within the second reference range.

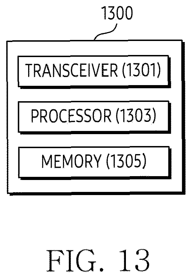

FIG. 13 illustrates an example of a functional configuration of an electronic device.

Referring to FIG. 13, an electronic device 1300 according to the above-described embodiments may be included in a base station (e.g., the base station 110 of FIG. 2) or a DU (e.g., the DU 210 of FIG. 2). The electronic device 1300 may correspond to the electronic device 700 of FIG. 7.

According to an embodiment, the electronic device 1300 may include a transceiver 1301, a processor 1303, memory 1305, and a backhaul transceiver 1307.

According to an embodiment, the electronic device 1300 may perform functions for transmitting and receiving a signal in a wired communication environment. The transceiver 1301 may include a wired interface for controlling a direct connection between devices through a transmission medium (e.g., copper wire, optical fiber). For example, the transceiver 1301 may transmit an electrical signal to another device through a copper wire, or may perform conversion between an electrical signal and an optical signal.

The transceiver 1301 may perform functions for transmitting and receiving a signal in a wireless communication environment. For example, the transceiver 1301 may perform a conversion function between a baseband signal and a bit string according to a physical layer standard of a system. For example, when transmitting data, the transceiver 1301 generates complex-valued symbols by encoding and modulating a transmission bit string. Furthermore, when receiving data, the transceiver 1301 restores a reception bit string by demodulating and decoding a baseband signal. Furthermore, the transceiver 1301 may include a plurality of transmitting/receiving paths.

The transceiver 1301 transmits and receives a signal as described above. Accordingly, all or portion of the transceiver 1301 may be referred to as 'communication unit', 'transmission unit', 'reception unit', or 'transmission/reception unit'. In addition, in the following description, transmission and reception performed through a wireless channel are used to include the processing performed by the transceiver 1301 as described above.

The processor 1303 controls overall operations of the electronic device 1300. The processor 1303 may be referred to as a controller. For example, the processor 1303 transmits and receives a signal through the transceiver 1301 (or through the backhaul transceiver 1307). In addition, the processor 1303 records and reads data in the memory 1305. In addition, the processor 1303 may perform functions of a protocol stack required by a communication standard. According to an embodiment, the processor 1303 may obtain a transmission signal at the terminal 120, based on a channel estimated using reception reference signals and a whitening matrix applied to reception data. For example, the processor 1303 may perform operation (or operation for circuits) of the functional blocks of FIG. 7. Although only the processor 1303 is illustrated in FIG. 13, according to another implementation, the electronic device 1300 may include two or more processors.

In the present disclosure, operations of the processor 1303 may mean being executed by software or controlling hardware components such as a Field Programmable Gate Array (FPGA) or an application-specific integrated circuit (ASIC). In addition, the processor 1303 may include at least one of components such as software components, object-oriented software components, class components, and task components, and processes, functions, attributes, procedures, subroutines, segments of program code, drivers, firmware, microcode, circuits, data, databases, data structures, tables, arrays, and variables. The processor 1303 may include at least one module, and the term 'module' includes a unit configured with hardware, software, or firmware. For example, 'module' may be used interchangeably with terms such as logic, logical block, component, or circuit. The 'module' may be an integrated component or a minimum unit performing one or more functions, or a part thereof. For example, the 'module' may be configured with ASIC.

For example, the processor 1303 may include at least some or all of the blocks (or circuits) illustrated in FIG. 7. The processor 1303 may perform functions of at least some or all of the blocks (circuits) illustrated in FIG. 7.

The memory 1305 stores data such as a basic program, an application program, and setting information for the operation of the electronic device 1300. The memory 1305 may be referred to as a storage unit. The memory 1305 may be configured with volatile memory, nonvolatile memory, or a combination of the volatile memory and the nonvolatile memory. In addition, the memory 1305 provides stored data according to a request of the processor 1303.

The electronic device 1300 may further include a backhaul transceiver 1307 for connection with a core network or other base stations. The backhaul transceiver 1307 provides an interface for performing communication with other nodes in a network. That is, the backhaul transceiver 1307 converts a bit string transmitted from a base station to another node (e.g., another access node, another base station, a upper node, a core network, and the like) into a physical signal, and converts a physical signal received from another node into a bit string.

According to the above-described embodiments, as the electronic device identifies whether an ADC calibration process operates normally and whether spur performance is normal, system stability may be ensured.

According to the above-described embodiments, a hardware defect included in a loopback path (e.g., calibration circuitry, receiving path, and transmitting path) for an ADC calibration process may be identified. For example, at least one of a failure of an RLC element for processing a digital signal and/or an analog signal, damage to a printed circuit board (PCB) pattern, abnormal operation of the electronic device, and a malfunction caused by a power anomaly of at least one component (or device) related to (or included in) the electronic device may be identified in advance. Accordingly, maintenance of a system including the electronic device may be facilitated. According to the above-described embodiments, there is an effect of being able to prevent a throughput decrease caused by abnormality of the ADC calibration process and a hardware defect. According to the above-described embodiments, cause analysis of a failure of the system (or the electronic device) may be facilitated.

According to an embodiment, an electronic device (e.g., the RU 220) may comprise digital to analogue converter (DAC) circuitry, analogue to digital converter (ADC) circuitry, first power amplifier circuitry, second power amplifier circuitry, coupling circuitry configured to connect a transmitting path between the DAC circuitry and the first power amplifier circuitry and a receiving path between the ADC circuitry and the second power amplifier circuitry, a radio frequency (RF) switch connected to the coupling circuitry, RF processing circuitry connected to the RF switch, an antenna connected to the RF processing circuitry, calibration circuitry for calibrating an output of the ADC circuitry, and at least one processor. The at least one processor may be configured to generate a reference signal based on a mode of the electronic device changed from a first mode in which one of the transmitting path and the receiving path is connected to the RF processing circuitry to a second mode in which the first power amplifier and the second power amplifier is activated. The at least one processor may be configured to, in response to transmitting the reference signal through the transmitting path, obtain a target signal changed from the reference signal through the receiving path. The at least one processor may be configured to obtain a calibration signal based on calibrating the target signal through the calibration circuitry. The at least one processor may be configured to, based on the reference signal and the calibration signal, identify anomaly of at least one of the calibration circuitry, the transmitting path, and the receiving path.

According to an embodiment, the at least one processor may be configured to transmit a signal based on time division duplex (TDD) in the first mode.

According to an embodiment, the at least one processor may be configured to identify a synchronization signal generated based on a time period corresponding to a length of a radio frame. The at least one processor may be configured to change, based on the synchronization signal, the mode of the electronic device from the first mode to the second mode.

According to an embodiment, the at least one processor may be configured to maintain the mode of the electronic device set as the second mode within the length of the radio frame.

According to an embodiment, the transmitting path may be activated based on the first power amplifier being activated. The receiving path may be activated based on the second power amplifier being activated.

According to an embodiment, the transmitting path may be used for transmitting a signal related to intermediate frequency in the first mode. The receiving path may be used for receiving a signal related to the intermediate frequency in the first mode.

According to an embodiment, the ADC circuitry and the calibration circuitry may be set to operate based on frequency division duplex (FDD) in the second mode.

According to an embodiment, the electronic device may comprise dump circuitry. The at least one processor may be configured to obtain the calibration signal output through the calibration circuitry using the dump circuitry.

According to an embodiment, the ADC circuitry may comprise time-interleaving ADC circuitry.

According to an embodiment, the reference signal may comprise a continuous wave (CW) signal.

According to an embodiment, the at least one processor may be configured to identify a first ratio which is a ratio of a maximum value of a cross correlation function between the reference signal and the calibration signal with respect to a maximum value of a cross correlation function between the reference signal and complex conjugate of the calibration signal.

According to an embodiment, the at least one processor may be configured to identify a second ratio which is a ratio of a maximum value of the cross correlation function between the reference signal and the calibration signal with respect to a maximum value of an auto correlation function of the calibration signal.

According to an embodiment, the at least one processor may be configured to identify the anomaly of at least one of the calibration circuitry, the transmitting path, and the receiving path based on identifying that the first ratio is out from a first reference range or the second ratio is out from a second reference range.

According to an embodiment, the at least one processor may be configured to identify anomaly of an ADC calibration process based on the first ratio being out from the first reference range. The at least one processor may be configured to identify anomaly of spur performance of the calibration circuitry based on the second ratio being out of the second reference range.

According to an embodiment, the at least one processor may be configured to identify that both the transmitting path and the receiving path are normal, based on the reference signal and the calibration signal. The at least one processor may be configured to change the mode of the electronic device from the second mode to the first mode, based on identifying that both the transmitting path and the receiving path are normal.

According to an embodiment, an electronic device (e.g., the RU 220) may comprise an array antenna comprising a plurality of antennas, RF processing circuits coupled with the array antenna, radio frequency (RF) switches connected to the RF processing circuits, couple circuits connected to the RF switches, and at least one processor. Each of coupled circuit of the coupling circuits may be configured to connect a transmitting path for a signal transmission and a receiving path for a signal reception. The transmitting path may be configured by digital to analogue converter (DAC) circuitry and first power amplifier circuitry. The receiving path may be configured by analogue to digital converter (ADC) circuitry and second power amplifier circuitry. The at least one processor may be configured to generate a reference signal based on a mode of the electronic device changed from a first mode in which one of the transmitting path and the receiving path is connected to the RF processing circuitry to a second mode in which the RF processing circuits are controlled to be in an idle state and the first power amplifier and the second power amplifier are activated. The at least one processor may be configured to, in response to transmitting the reference signal through the transmitting path, obtain a target signal changed from the reference signal through the receiving path. The at least one processor may be configured to obtain a calibration signal based on calibrating the target signal through the calibration circuitry. The at least one processor may be configured to, based on the reference signal and the calibration signal, identify anomaly of at least one of the calibration circuitry, the transmitting path, and the receiving path.

According to an embodiment, the at least one processor may be configured to identify a first ratio which is a ratio of a maximum value of a cross correlation function between the reference signal and the calibration signal with respect to a maximum value of a cross correlation function between the reference signal and complex conjugate of the calibration signal.

According to an embodiment, the at least one processor may be configured to identify a second ratio which is a ratio of a maximum value of the cross correlation function between the reference signal and the calibration signal with respect to a maximum value of an auto correlation function of the calibration signal.

According to an embodiment, the at least one processor may be configured to identify the anomaly of at least one of the calibration circuitry, the transmitting path, and the receiving path based on identifying that the first ratio is out from a first reference range or the second ratio is out from a second reference range.

According to an embodiment, the at least one processor may be configured to identify that both the transmitting path and the receiving path are normal, based on the reference signal and the calibration signal. The at least one processor may be configured to change the mode of the electronic device from the second mode to the first mode, based on identifying that both the transmitting path and the receiving path are normal.

Methods according to embodiments described in claims or specifications of the present disclosure may be implemented as a form of hardware, software, or a combination of hardware and software.

In a case of implementing as software, a computer-readable storage medium for storing one or more programs (software module) may be provided. The one or more programs stored in the computer-readable storage medium are configured for execution by one or more processors in an electronic device. The one or more programs include instructions that cause the electronic device to execute the methods according to embodiments described in claims or specifications of the present disclosure. The one or more programs may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore™), or between two user devices (e.g., smart phones) directly. In the case of being distributed online, at least part of the computer program product may be temporarily generated or at least temporarily stored in the machine-readable storage medium, such as memory of the manufacturer's server, the application store's server, or a relay server.

Such a program (software module, software) may be stored in a random access memory, a non-volatile memory including a flash memory, a read only memory (ROM), an electrically erasable programmable read only memory (EEPROM), a magnetic disc storage device, a compact disc-ROM (CD-ROM), an optical storage device (digital versatile discs (DVDs) or other formats), or a magnetic cassette. Alternatively, it may be stored in memory configured with a combination of some or all of them. In addition, a plurality of configuration memories may be included.

Additionally, a program may be stored in an attachable storage device that may be accessed through a communication network such as the Internet, Intranet, local area network (LAN), wide area network (WAN), or storage area network (SAN), or a combination thereof. Such a storage device may be connected to a device performing an embodiment of the present disclosure through an external port. In addition, a separate storage device on the communication network may also be connected to a device performing an embodiment of the present disclosure.

**EP 4 664 796 A1**

In the above-described specific embodiments of the present disclosure, components included in the disclosure are expressed in the singular or plural according to the presented specific embodiment. However, the singular or plural expression is selected appropriately according to a situation presented for convenience of explanation, and the present disclosure is not limited to the singular or plural component, and even components expressed in the plural may be configured in the singular, or a component expressed in the singular may be configured in the plural.

According to various embodiments, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as they are performed by a corresponding one of the plurality of components before the integration. According to various embodiments, operations performed by the module, the program, or another component may be executed sequentially, in parallel, repeatedly, or heuristically, or one or more of the operations may be executed in a different order or omitted, or one or more other operations may be added.

Meanwhile, specific embodiments have been described in the detailed description of the present disclosure, and of course, various modifications are possible without departing from the scope of the present disclosure.

## Claims

1.  An electronic device comprising:

    digital to analogue converter (DAC) circuitry;
    analogue to digital converter (ADC) circuitry;
    first power amplifier circuitry;
    second power amplifier circuitry;
    coupling circuitry configured to connect a transmitting path between the DAC circuitry and the first power amplifier circuitry and a receiving path between the ADC circuitry and the second power amplifier circuitry;
    a radio frequency (RF) switch connected to the coupling circuitry;
    RF processing circuitry connected to the RF switch;
    an antenna connected to the RF processing circuitry;
    calibration circuitry for calibrating an output of the ADC circuitry; and
    at least one processor, wherein the at least one processor is configured to:

    generate a reference signal based on a mode of the electronic device changed from a first mode in which one of the transmitting path and the receiving path is connected to the RF processing circuitry to a second mode in which the first power amplifier and the second power amplifier are activated,
    in response to transmitting the reference signal through the transmitting path, obtain a target signal changed from the reference signal through the receiving path,
    obtain a calibration signal based on calibrating the target signal through the calibration circuitry, and
    based on the reference signal and the calibration signal, identify anomaly of at least one of the calibration circuitry, the transmitting path, and the receiving path.

2.  The electronic device of claim 1, wherein the at least one processor is further configured to transmit a signal based on time division duplex (TDD) in the first mode.

3.  The electronic device of any one of claims 1 to 2, wherein in the at least one processor is further configured to:

    identify a synchronization signal generated based on a time period corresponding to a length of a radio frame, and
    change, based on the synchronization signal, the mode of the electronic device from the first mode to the second mode.

4.  The electronic device of claim 3, wherein in the at least one processor is further configured to maintain the mode of the electronic device set as the second mode within the length of the radio frame.

5.  The electronic device of any one of claims 1 to 4, wherein the transmitting path is activated based on the first power amplifier being activated, and
    wherein the receiving path is activated based on the second power amplifier being activated.

6. The electronic device of any one of claims 1 to 5, wherein the transmitting path is used for transmitting a signal related to intermediate frequency in the first mode, and
wherein the receiving path is used for receiving a signal related to the intermediate frequency in the first mode.

7. The electronic device of any one of claims 1 to 6, wherein the ADC circuitry and the calibration circuitry are set to operate based on frequency division duplex (FDD) in the second mode.

8. The electronic device of any one of claims 1 to 7, wherein the electronic device further comprises dump circuitry, and wherein the at least one processor is further configured to obtain the calibration signal output through the calibration circuitry using the dump circuitry.

9. The electronic device of any one of claims 1 to 8, wherein the ADC circuitry comprises time-interleaving ADC circuitry.

10. The electronic device of any one of claims 1 to 9, wherein the reference signal comprises a continuous wave (CW) signal.

11. The electronic device of any one of claims 1 to 10, wherein the at least one processor is further configured to identify a first ratio which is a ratio of a maximum value of a cross correlation function between the reference signal and the calibration signal with respect to a maximum value of a cross correlation function between the reference signal and complex conjugate of the calibration signal.

12. The electronic device of claim 11, wherein the at least one processor is further configured to identify a second ratio which is a ratio of a maximum value of the cross correlation function between the reference signal and the calibration signal with respect to a maximum value of an auto correlation function of the calibration signal.

13. The electronic device of claim 12, wherein the at least one processor is configured to identify the anomaly of at least one of the calibration circuitry, the transmitting path, and the receiving path based on identifying that the first ratio is out from a first reference range or the second ratio is out from a second reference range.

14. The electronic device of claim 13, wherein the at least one processor is further configured to:

    identify anomaly of an ADC calibration process based on the first ratio being out from the first reference range, and
    identify anomaly of spur performance of the calibration circuitry based on the second ratio being out of the second reference range.

15. An electronic device comprising:

    an array antenna comprising a plurality of antennas;
    RF processing circuits coupled with the array antenna;
    radio frequency (RF) switches connected to the RF processing circuits;
    couple circuits connected to the RF switches;and
    at least one processor,
    wherein each of the coupling circuits is configured to connect a transmitting path for a signal transmission and a receiving path for a signal reception,
    wherein the transmitting path is configured by digital to analogue converter (DAC) circuitry and first power amplifier circuitry.
    wherein the receiving path is configured by analogue to digital converter (ADC) circuitry and second power amplifier circuitry,
    wherein the at least one processor is configured to:

        generate a reference signal based on a mode of the electronic device changed from a first mode in which one of the transmitting path and the receiving path is connected to the RF processing circuitry to a second mode in which the RF processing circuits are controlled to be in an idle state and the first power amplifier and the second power amplifier are activated,
        in response to transmitting the reference signal through the transmitting path, obtain a target signal changed from the reference signal through the receiving path,
        obtain a calibration signal based on calibrating the target signal through the calibration circuitry, and
        based on the reference signal and the calibration signal, identify anomaly of at least one of the calibration circuitry, the transmitting path, and the receiving path.

FIG. 1A

FIG. 1B

110

210

215

220

DU

RU

FIG. 2

RADIO FRAME (314)

SLOT (306)

RESOURCE ELEMENT (312)

$N_{RB}^{DL}$ OR $N_{RB}^{DL}$ SUBCARRIERS (304)

$N_{RB}$ SUBCARRIERS (310)

RESOURCE BLOCK (308)

$N_{symb}$ OFDM SYMBOLS (302)

FIG. 3

FIG. 4

FIG. 5

220

Control Block
(FPGA)
~619

RU

~210

DU
(320)

~611

DAFE Block
(320)

~613

IF Up/Down
Converter
(RFBs)

~615

Beamformer
(RFAs)

~617

Array
antenna

FIG. 6

FIG. 7

FIG. 8

FIG. 9A

FIG. 9B

FIG. 10A

FIG. 10B

FIG. 11A

correlation

FIG. 11B

GENERATE REFERENCE SIGNAL ~1210

OBTAIN TARGET SIGNAL CHANGED FROM REFERENCE SIGNAL ~1220

OBTAIN CALIBRATION SIGNAL BASED ON CALIBRATING OF TARGET SIGNAL THROUGH CALIBRATION CIRCUITRY ~1230

IDENTIFY ANOMALY OF AT LEAST ONE OF CALIBRATION CIRCUITRY, TRANSMITTING PATH, AND RECEIVING PATH ~1240

FIG. 12

1300

TRANSCEIVER (1301)

PROCESSOR (1303)

MEMORY (1305)

FIG. 13

## INTERNATIONAL SEARCH REPORT

| International application No. |
| --- |
| **PCT/KR2024/001282** |

**A. CLASSIFICATION OF SUBJECT MATTER**

**H04B 17/14**(2015.01)i; **H04B 17/21**(2015.01)i; **H04B 1/401**(2015.01)i; **H03M 1/12**(2006.01)i; **H03M 1/06**(2006.01)i; **H03M 1/10**(2006.01)i; **H04L 5/00**(2006.01)i

According to International Patent Classification (IPC) or to both national classification and IPC

**B. FIELDS SEARCHED**

Minimum documentation searched (classification system followed by classification symbols)

H04B 17/14(2015.01); G01S 3/48(2006.01); H03M 1/06(2006.01); H03M 1/10(2006.01); H03M 1/12(2006.01); H04L 25/02(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 디지털 아날로그 변환기(digital to analog converter, DAC), 아날로그 디지털 변환기(analog to digital converter, ADC), 보정(calibration), 포그라운드(foreground), 에러(error), 참조 신호(reference signal), 활성(active), 비활성(inactive), 유휴(idle), 대상 신호(target signal), 고주파(high frequency), 시간 인터리브(time-interleaved), 루프백(loop back)

**C. DOCUMENTS CONSIDERED TO BE RELEVANT**

| Category* | Citation of document, with indication, where appropriate, of the relevant passages | Relevant to claim No. |
| --- | --- | --- |
| Y | KR 10-2023-0010400 A (SAMSUNG ELECTRONICS CO., LTD. et al.) 19 January 2023 (2023-01-19)<br>See paragraphs [0016]-[0017], [0019], [0021], [0032], [0068] and [0071]-[0075]; and figures 1 and 12. | 1-15 |
| Y | US 11539371 B1 (QUALCOMM INCORPORATED) 27 December 2022 (2022-12-27)<br>See column 4, lines 1-56 and column 5, line 51 - column 6, line 29; and figures 2-3. | 1-15 |
| Y | US 2022-0038110 A1 (OMNI DESIGN TECHNOLOGIES INC.) 03 February 2022 (2022-02-03)<br>See paragraphs [0034]-[0037]; claim 1; and figure 3. | 1-15 |
| Y | SINGH, Simran. Time-Interleaved Analog-to-Digital-Converters: Modeling, Blind Identification and Digital Correction of Frequency Response Mismatches. Tampere University of Technology. 2016.<br>[retrieved on 26 April 2024]. Retrieved from <https://trepo.tuni.fi/handle/10024/114593>.<br>See pages 19, 57 and 61-62. | 11-14 |

☑ Further documents are listed in the continuation of Box C.    ☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **09 May 2024** | **09 May 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**

| International application No. |
| --- |
| **PCT/KR2024/001282** |

| C. | DOCUMENTS CONSIDERED TO BE RELEVANT | |
| --- | --- | --- |
| Category* | Citation of document, with indication, where appropriate, of the relevant passages | Relevant to claim No. |
| A | US 2020-0081089 A1 (KABUSHIKI KAISHA TOSHIBA et al.) 12 March 2020 (2020-03-12)<br>See paragraphs [0040]-[0044]; and figure 1. | 1-15 |

Form PCT/ISA/210 (second sheet) (July 2022)

## INTERNATIONAL SEARCH REPORT
### Information on patent family members

International application No.

**PCT/KR2024/001282**

| Patent document cited in search report | | | Publication date (day/month/year) | Patent family member(s) | | | Publication date (day/month/year) |
|---|---|---|---|---|---|---|---|
| KR | 10-2023-0010400 | A | 19 January 2023 | US | 2023-0011449 | A1 | 12 January 2023 |
| US | 11539371 | B1 | 27 December 2022 | WO | 2023-049634 | A1 | 30 March 2023 |
| US | 2022-0038110 | A1 | 03 February 2022 | US | 11545990 | B2 | 03 January 2023 |
| US | 2020-0081089 | A1 | 12 March 2020 | JP | 2020-043441 | A | 19 March 2020 |
| | | | | JP | 7091197 | B2 | 27 June 2022 |
| | | | | US | 11333735 | B2 | 17 May 2022 |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- FR 1310